(19) Europäisches Patentamt / European Patent Office / Office européen des brevets

(11) **EP 3 240 004 B1**

(12) **EUROPEAN PATENT SPECIFICATION**

(45) Date of publication and mention
of the grant of the patent:
**07.04.2021 Bulletin 2021/14**

(21) Application number: **15873191.9**

(22) Date of filing: **24.12.2015**

(51) Int Cl.:
***H01H 9/54*** *(2006.01)*        ***H01H 33/59*** *(2006.01)*
***H02H 3/087*** *(2006.01)*

(86) International application number:
**PCT/JP2015/086056**

(87) International publication number:
**WO 2016/104623 (30.06.2016 Gazette 2016/26)**

(54) **CIRCUIT BREAKER**

SCHUTZSCHALTER

DISJONCTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.12.2014 JP 2014266566**

(43) Date of publication of application:
**01.11.2017 Bulletin 2017/44**

(73) Proprietor: **Tokyo Institute of Technology
Tokyo 152-8550 (JP)**

(72) Inventors:
• **AKAGI, Hirofumi
Tokyo 152-8550 (JP)**

• **HAGIWARA, Makoto
Tokyo 152-8550 (JP)**

(74) Representative: **Krauns, Christian
Wallinger Ricker Schlotter Tostmann
Patent- und Rechtsanwälte Partnerschaft mbB
Zweibrückenstraße 5-7
80331 München (DE)**

(56) References cited:
WO-A1-2014/094847     WO-A1-2014/094847
WO-A1-2014/131298     JP-A- H0 589 753
JP-A- S6 235 420      JP-A- H04 259 719
JP-A- 2000 067 715    JP-A- 2003 346 612
JP-A- 2014 235 834

**Description**

Technical Field

The present invention relates to a circuit breaker interrupting a current path upon the occurrence of an accident such as ground fault and short circuit, and more particularly to a hybrid type circuit breaker using mechanical-switching and semiconductor-switching methods in combination.

Background Art

In recent years, power supply systems using direct current (DC) attract much attention. DC power supply systems have an advantage of reducing converter loss, transmission loss, and installation cost, as compared with existing AC power supply systems. In Japan, for example, a DC power supply system using direct current up to 380 [V] with converter capacity as large as 500 [kW], and DC power supply systems for tramways (600 [V] and 750 [V]) or for DC electric railcars (1,000 [V] and 1,500 [V]) have become in practical use. For high voltage applications at several tens [kV] or more, for example, a multi-terminal High-Voltage Direct Current (HVDC) transmission system using a voltage-fed converter is expected to be introduced in prospect of installation of a large number of offshore wind farm systems in the future.

When an accidental ground fault or short circuit occurs in a DC power supply system, an over-current occurs. The current increase rate ([A/s]) from the accidental occurrence is inversely proportional to the DC inductance of the DC power supply system. For example, when DC voltage is generated using a voltage-fed converter, an over-current may occur owing to the small DC inductance, and therefore, a DC circuit breaker capable of operating at high speed is required to be installed.

The DC circuit breaker can be classified into three types: a mechanical switch type, a semiconductor switch type, and a hybrid type.

Among these types, the mechanical switch type interrupts the current by using, for example, not only a mechanical breaker (circuit breaker), such as a vacuum circuit breaker, a gas circuit breaker, and an air blown circuit breaker, but also an LC resonance circuit (see, for example, Non-patent literature 1). The mechanical switch type does not use power devices, and therefore it does not cause steady loss.

In contrast, the semiconductor switch type uses a circuit breaker configured by a power device (power semiconductor element), so as to achieve a rapid (1 [ms] or less) interruption time (for example, see Non-patent literature 2).

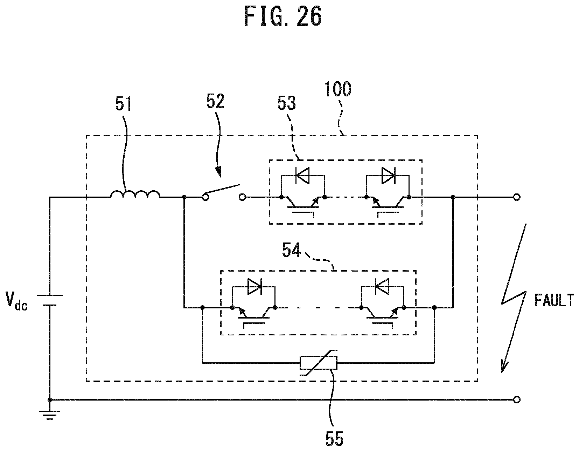

Further, the hybrid type is characterized by using a mechanical breaker capable of high speed operation and a power device in combination, to achieve both high speed interruption of current and reduction of loss, and various circuits for hybrid-type use also have been proposed (for example, see Non-patent literature 3). FIG. 26 is a circuit diagram exemplifying a general hybrid-type circuit breaker. For example, as illustrated in FIG. 26, the hybrid-type circuit breaker 100 includes a main circuit configured by an inductor for limiting current 51, a mechanical breaker (circuit breaker) 52, a semiconductor commutation switch 53, a main semiconductor switch 54, and an arrester (nonlinear resistor) 55. In normal operation, electric power is supplied to a load via the inductor for limiting current 51, the mechanical breaker 52, and the semiconductor commutation switch 53, and upon the occurrence of an accident such as ground fault and short circuit, the semiconductor commutation switch 53 is turned off to commutate a current to the main semiconductor switch 54. Breakdown voltage required for the semiconductor commutation switch 53 is about several percent of that of the main semiconductor switch 54, and therefore, hybrid type circuit breakers have an advantage of reducing the steady loss, as compared with semiconductor switch types. In addition, hybrid type circuit breakers require a time for the commutation of less than 0.2 [ms], thereby enabling reducing the interruption time to 2 [ms] or less by using a mechanical breaker 52 that can be opened within 1 [ms].

Citation List

Non-Patent Literatures

Non-patent literature 1: B. Bachmann, G. Mauthe, E. Ruoss, and H. P. Lips, 'Development of a 500 kV Airblast HVDC Circuit Breaker' (USA), IEEE Transactions, Electrical Power Apparatus and Systems, Vol. PAS-104, No. 9, pp. 2460-2466, September 1985.
Non-patent literature 2: C E Meyers, S. Schroder, and R. W. De Doncker, 'Solid-State Circuit Breakers and Current Limiters For Medium-Voltage Systems Having Distributed Power Systems' (USA), IEEE Transactions, Power Electron, Vol. 19, No. 5, pp. 1333-1340, September 2004.

Non-patent literature 3: M.Steurer, K. Frohlich, W. Holaus, and K. Kaltenegger 'A Novel Hybrid Current-Limiting Circuit Breaker For Medium Voltage: Principle and Test Results', (USA), IEEE Transactions, Power Deli, Vol. 18, No .2, pp. 460-467, April 2003.

Summary of Invention

Technical Problem

Circuit breakers of mechanical switch type, despite having an advantage of not causing steady loss because they do not use power devices, require a long time for current interruption (opening time) of 30 to 100 [ms], and therefore, they are difficult to be applied to voltage-fed converters, although applicable to current-fed converters having a large DC inductance.

In contrast, circuit breakers of semiconductor switch type have a problem of causing steady loss owing to a current constantly flowing in their internal semiconductor switch. Further, a high voltage higher than DC voltage is applied to the internal semiconductor switch during current interruption, and therefore, the switch is desirably designed to have a high breakdown voltage by using a plurality of power devices connected in series with each other. In this case, increase in the on-voltage of the semiconductor switch becomes problematic. For example, for a case of DC 320 [kV], the on-voltage of the semiconductor switch is 100 [V] or higher. Since a current flows constantly through the semiconductor switch, reducing loss caused by the on-voltage is a problem to be solved.

In the above circuit breakers of hybrid type, the required breakdown voltage for their semiconductor commutation switch is about several percent of that of their main semiconductor switch, and therefore, the steady loss can be reduced in comparison with semiconductor switch types and the interruption time can also be shortened in comparison with mechanical switch types. However, the steady loss cannot be reduced to zero because the steady current still flows in normal operation through the semiconductor commutation switch. The WO 2014/094847 discloses a device for switching a pole of a direct current network having two connecting terminals to be connected in series with the pole, an operating current branch extending between the connecting terminals, in which there is arranged at least one mechanical switch, a shutdown branch, in which a power switching unit is arranged that is equipped to shut down high short-circuit currents and has power semiconductor switches that can be switched on and off, and commutation means for commutating the current from the operating current path to the shutdown path.

Accordingly, in view of the above-mentioned problems, an object of the present invention is to provide a circuit breaker that can interrupt a current path at a high speed upon the occurrence of an accident and has no steady loss in normal operation.

Solution to Problem

For solving the object of the present invention, a circuit breaker according to the independent claims 1 or 2 is provided.

Advantageous Effects of Invention

According to the present invention, a circuit breaker can be achieved which has no steady loss in normal operation and can interrupt a current path at a high speed upon the occurrence of an accident.

The circuit breaker according to the present invention is a so-called hybrid circuit breaker provided with a mechanical breaker and one or more semiconductor power converters, which circuit breaker can reduce the steady loss in normal operation of the circuit breaker to zero because in normal operation its mechanical breaker is turned on to supply electric power from the power supply side to the load side, with the one or more semiconductor power converters simply operating as a diode.

Further, according to the present invention, when an over-current occurs owing to an accidental ground fault or short circuit, the current path can be interrupted at high speed by appropriately controlling the operation of the mechanical breaker and the one or more semiconductor power converters.

Still further, according to the present invention, high breakdown voltage of the circuit breaker can be easily achieved simply by appropriately adjusting the number of the semiconductor power converters to be cascade-connected with each other.

Still further, according to the present invention, the current path can be interrupted, regardless of the amplitude and polarity of the direct current, by a DCDC converter in the one or more semiconductor power converters configured as a 4-quadrant DCDC converter.

Brief Description of Drawings

FIG. 1 is a circuit diagram illustrating a circuit breaker according to a general First Example, not being an example of the present invention;

FIG. 2 is a circuit diagram explaining a semiconductor power converter in the circuit breaker according to First Example;

FIG. 3A is a circuit diagram explaining an example of the placement of a second inductor in the circuit breaker according to First Example (part 1);

FIG. 3B is a circuit diagram explaining an example of the placement of the second inductor in the circuit breaker according to First Example (part 2);

FIG. 3C is a circuit diagram explaining an example of the placement of the second inductor in the circuit breaker according to First Example (part 3);

FIG. 4 is a block diagram explaining a control system in the circuit breaker according to First Example;

FIG. 5 is a flowchart illustrating an operational flow of the circuit breaker according to First Example;

FIG. 6A is a circuit diagram illustrating an equivalent circuit for explaining the operation of the circuit breaker according to First Example (part 1);

FIG. 6B is a circuit diagram illustrating an equivalent circuit for explaining the operation of the circuit breaker according to First Example (part 2);

FIG. 6C is a circuit diagram illustrating an equivalent circuit for explaining the operation of the circuit breaker according to First Example (part 3);

FIG. 6D is a circuit diagram illustrating an equivalent circuit for explaining the operation of the circuit breaker according to First Example (part 4);

FIG. 7 is a control block diagram explaining a power conversion command for controlling a converter current in semiconductor power converters in the circuit breaker according to First Example;

FIG. 8A is a circuit diagram used for a simulation of the circuit breaker according to First Example, wherein an accidental short circuit occurs in the close vicinity of the ends of the circuit breaker for a case of an RL load connected to the circuit breaker;

FIG. 8B is a circuit diagram used for a simulation of the circuit breaker according to First Example, wherein an accidental short circuit occurs in the close vicinity of the ends of the circuit breaker for a case of a regenerative load connected to the circuit breaker;

FIG. 9 is a table listing circuit parameters for the simulation circuit diagrams illustrated in FIG. 8A and FIG. 8B;

FIG. 10 is a diagram indicating a simulated waveform for the circuit breaker according to First Example operated by the simulation circuit of FIG. 8A;

FIG. 11 is a diagram indicating the waveform in FIG. 10 enlarged on the time axis;

FIG. 12 is a diagram indicating a simulated waveform for the circuit breaker according to First Example operated by the simulation circuit of FIG. 8B;

FIG. 13 is a circuit diagram illustrating a variation example of the circuit breaker according to First Example;

FIG. 14 is a diagram indicating a simulated waveform for the circuit breaker according to the variation example of First Example operated by the simulation circuit of FIG. 8A;

FIG. 15 is a diagram indicating a simulated waveform for the circuit breaker according to the variation example of First Example operated by the simulation circuit of FIG. 8B;

FIG. 16 is a circuit diagram explaining semiconductor power converters in a circuit breaker according to a Second Example, the Second Example being an example of the present invention;

FIG. 17 is a control block diagram explaining a power conversion command for controlling a converter current in semiconductor power converters in the circuit breaker according to Second Example;

FIG. 18A is a block diagram explaining a first variation example of a current detector used to control a converter current in the semiconductor power converters in the circuit breaker according to Second Example;

FIG. 18B is a diagram exemplifying the first variation example of the current detector explained in FIG. 18A;

FIG. 19 is a block diagram illustrating a second variation example of the current detector used to control a converter current in the semiconductor power converters in the circuit breaker according to Second Example;

FIG. 20 is a circuit diagram explaining semiconductor power converters in a circuit breaker according to a Third Example, the Third Example being also an example of the present invention;

FIG. 21 is a circuit diagram explaining a first variation example of an energy storage unit in each of the semiconductor power converters in the circuit breaker according to Second Example;

FIG. 22A is a circuit diagram explaining the operation of the energy storage unit illustrated in FIG. 21 (part 1);

FIG. 22B is a circuit diagram explaining the operation of the energy storage unit illustrated in FIG. 21 (part 2);

FIG. 22C is a circuit diagram explaining the operation of the energy storage unit illustrated in FIG. 21 (part 3);
FIG. 23 is a diagram indicating a simulated waveform for the circuit breaker illustrated in FIG. 21 in operation;
FIG. 24 is a circuit diagram explaining a second variation example of the energy storage unit in each of the semiconductor power converters in the circuit breaker according to Second Example;
FIG. 25 is a block diagram explaining a control system in the circuit breaker illustrated in FIG. 24; and
FIG. 26 is a circuit diagram exemplifying a general hybrid type circuit breaker.

Description of Embodiments

The circuit breaker according to the present invention is provided with a first inductor, a mechanical breaker, one or more semiconductor power converters, and a second inductor. The first inductor has a first external connection terminal at one end thereof. The mechanical breaker, which is opened to interrupt a current path in response to a command, is connected in series with the first inductor and has a second external connection terminal on one side thereof opposite to the other side thereof connected to the first inductor. The one or more semiconductor power breakers, which output a certain current in response to a command, are provided singly or in a form of cascade-connection to each other, on a wire branching from a wire connecting the first inductor to the mechanical breaker. The second inductor is connected in series with the semiconductor power converter(s) or the mechanical breaker. One of the first and second inductors is an inductor for limiting an accidental current and the other is an inductor for current control. Now, specific circuit configurations will be explained in First to Third Examples.

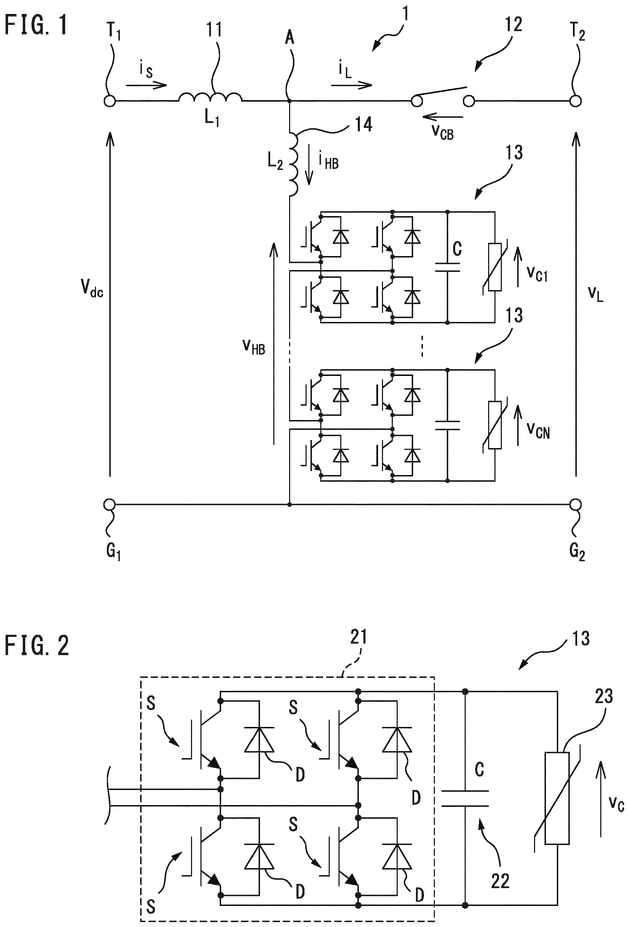

FIG. 1 is a circuit diagram illustrating a circuit breaker according to First Example, not being an example of the present invention, and FIG. 2 is a circuit diagram explaining a semiconductor power converter in the circuit breaker according thereto. Hereafter, the same reference signs in different drawings indicate components having the same function. A circuit breaker 1 according to First Example is provided with a first inductor 11, a mechanical circuit breaker 12, one or more semiconductor power converter 13, and a second inductor 14. The circuit breaker 1 according to First Example is placed so that the semiconductor power converter(s) 13 may be connected in parallel with an applied DC power supply system, and the first inductor 11 and the mechanical circuit breaker 12 are placed so as to be on the power supply side and on the load side, respectively.

The first inductor 11 has a first external connection terminal $T_1$ at one end thereof. The first external connection terminal $T_1$ is connected to a circuit on the power supply side.

The mechanical circuit breaker 12 is connected in series with the first inductor 11, and has a second external connection terminal $T_2$ on one side thereof opposite to the other side thereof connected to the first inductor 11. The second external connection terminal $T_2$ is connected to a circuit on the load side. The mechanical circuit breaker 12 includes a fixed contact and a mobile contact movable between a circuit-closing position where the contact is in contact to the fixed contact and a circuit-opening position where the contact is separated from the fixed contact, wherein the mobile contact is separated from the fixed contact and opens the breaker to interrupt a current path in response to a command. Examples of the mechanical breaker 12 include a vacuum circuit breaker, a gas circuit breaker, and an air blown circuit breaker.

The one or more semiconductor power converters 13 are provided, singly or in a form of cascade-connection to each other, on a wire branching from a wire connecting the first inductor 11 to the mechanical circuit breaker 12. In this specification, when a single semiconductor power converter 13 is used, one side thereof connected to the second inductor 14 is referred to as a 'first DC side', and when a plurality of semiconductor power converters 13 are cascade-connected with each other, one side of each of the semiconductor power converters connected to another semiconductor power converter 13 different from the semiconductor power converter is referred to as a 'first DC side.' Further, the other DC side opposite to the 'first DC side' is referred to as a 'second DC side.' FIG. 1 explains an example in which a plurality of semiconductor power converters 13 (N converters, where *N* is an integer of 2 or more) are cascade-connected with each other on the first DC side. High breakdown voltage can be easily achieved for the circuit breaker 1 simply by appropriately adjusting the number of the semiconductor power converters 13 to be cascade-connected.

Each of the semiconductor power converters 13 includes a DCDC converter 21, an energy storage unit 22 and a nonlinear resistor 23, and outputs a certain direct current by making, in response to a command, semiconductor switches provided in the DCDC converter 21 carry out their switching operation.

The DC-DC converter 21 in the semiconductor power converter 13 is configured as a so-called 4-quadrant DCDC converter. In other words, the DCDC converter 21 converts, by the switching operation of the semiconductor switches S, a direct current input from one of the first and second DC sides into a direct current having a desired magnitude and polarity and outputs the current to the other side, wherein the input-output direction of the direct current can be switched between the first and second DC sides. The current path can be interrupted, regardless of the amplitude and polarity of the direct current, by the DC-DC converter 21 configured so as to be a 4-quadrant DCDC converter in the semiconductor power converter 13. Each of the semiconductor switches is configured by a semiconductor switching element S allowing, when turned on, a current to flow unidirectionally and a feedback diode D connected in anti-parallel with the semiconductor switching element S. Examples of the semiconductor switching element S includes an IGBT, a thyristor, a GTO (Gate Turn-Off thyristor), and a transistor, but the type of the switching element does not limit by itself the present invention, and other semiconductor elements may be used.

The energy storage unit 22 in the semiconductor power converter 13 is connected in parallel with the DCDC converter 21 on the second DC side. Examples of the energy storage unit 22 include a DC capacitor. For a case of the DC capacitor, it is charged in advance by the operation of the DCDC converter 21 when the circuit breaker 1 is made operate.

The nonlinear resistor 23 in the semiconductor power converter 13 is an element which is connected in parallel with the energy storage unit 22 and exhibits a certain resistance value when a DC voltage applied to the energy storage unit 22 is less than a preset voltage (hereinafter referred to as 'operation voltage') or less and otherwise a resistance value lower than the certain value. Examples of the nonlinear resistor 23 include an MOV (Metal Oxide Variable resistor) (also referred to as a 'varistor' or an 'arrester'). The operation voltage of the nonlinear resistor 23 is limited to the rated voltage of a power device to be used. For example, when a power device having a breakdown voltage of 3.3 [kV], the operation voltage $V_R$ of the nonlinear resistor 23 is desirably 3.3 [kV] or less.

The DC capacitor 22 is connected in parallel with the nonlinear resistor 23, and therefore, when the DC capacitor 22 is charged with energies stored in the first inductor 11 and the second inductor 14, the charging voltage of the DC capacitor 22, after gradually increased up to the operation voltage of the nonlinear resistor 23, is clamped at the charging voltage of the nonlinear resistor 23, and the energies stored in the first inductor 11 and the second inductor 14 are consumed by the nonlinear resistor 23. The energy storage unit 22 and the nonlinear resistor 23 may also be implemented by other elements as long as they carry out the above series of operations, *i.e.*, charging of the DC capacitor 22 and the consumption of the energy by the nonlinear resistor 23, and accordingly, they may be replaced with an element, such as a secondary battery and an electric double-layer capacitor.

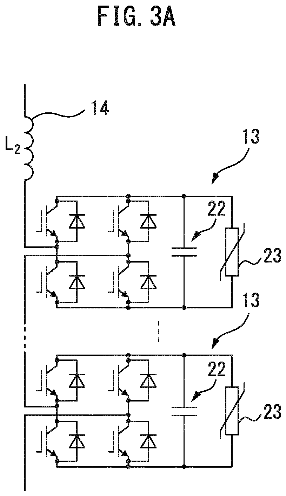

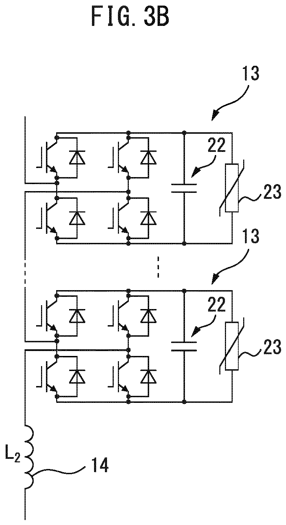

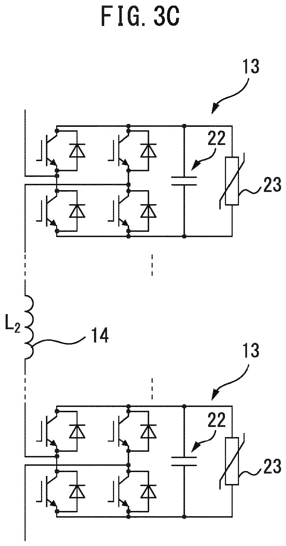

In First Example, the second inductor 14 is connected in series with the one or more semiconductor power converters 13. When a plurality of semiconductor power converters 13 are cascade-connected with each other, the second inductor 14 is connected in series with any one of the semiconductor power converters 13 cascade-connected with each other. FIG. 3A to FIG. 3C are circuit diagrams explaining examples of the placement of the second inductor in the circuit breaker according to First Example. For example, as illustrated in FIG. 3A and FIG. 3B, the second inductor 14 is placed on one side of any one of semiconductor power converters 13 placed at both ends of the cascade-connection, which side is not connected to another semiconductor power converter 13. Further, as illustrated in FIG. 3C, the second inductor 14 is, for example, placed between semiconductor power converters 13 adjacent to each other.

When a single semiconductor power converter 13 is used, the second inductor 14 is simply connected in series with the semiconductor power converter 13.

Whether a plurality of semiconductor power converters 13 are cascade-connected with each other or a single semiconductor power converter 13 is used, the second inductor 14 will be provided on any position on the same wire to which the one or more semiconductor power converters 13 are connected. In First Example, the unit configured by the semiconductor power converters 13 and the second inductor 14 both placed on the same wire is connected to a connection point A of the first inductor 11 and the mechanical circuit breaker 12.

In First Example, a first inductor 11, a mechanical circuit breaker 12, one or more semiconductor power converters 13, and a second inductor 14 are connected as described above, and a unit configured by the one or more semiconductor power converters 13 and the second inductor 14 both placed on the same wire has respective pairs of terminals on both sides thereof, one of which pairs, on one side thereof opposite to the other side thereof connected to the connection point A, is determined to be ground terminals $G_1$ and $G_2$.

In this Example, the circuit breaker 1 operating as a DC circuit breaker was described, but the circuit breaker 1 can operate also as an AC breaker, and in this case, the unit configured by the one or more semiconductor power converters 13 and the second inductor 14 both placed on the same wire has respective pairs of terminals on both sides thereof, one of which pairs, on one side thereof opposite to the other side thereof connected to the connection point A, is determined to be terminals $G_1$ and $G_2$ having an polarity opposite to that of a first external connection terminal $T_1$ and a second external connection terminal $T_2$. In addition, when circuit breaker 1 operates as an AC breaker, the DCDC converter 21 in each of the semiconductor power converter 13 operates as a DCAC converter (Direct Current Alternating Current converter). In this case, the DC side of the DCAC converter corresponds to the above-mentioned 'second DC side', and the AC side corresponds to the above-mentioned 'first DC side.'

In the example illustrated in FIG. 1, the side including the first external connection terminal $T_1$ and the ground terminal $G_1$ is determined to be the power supply side and the side including the second external connection terminal $T_2$ and the ground terminal $G_2$ is determined to be the load side. Therefore, the first inductor 11 functions as an inductor for limiting an accidental current, and the second inductor 14 functions as an inductor for current control.

Hereinafter, a DC voltage on the power supply side is represented by $V_{dc}$, a load voltage by $V_L$, a voltage appearing across the mechanical circuit breaker 12 by $v_{CB}$, a total voltage across the cascade-connected semiconductor power converters by $v_{HB}$. Further, the voltage of the DC capacitor connected in parallel with each of the semiconductor power converters 13 is represented by $v_{C1}$ ... or $v_{CN}$ (where $N$ is a natural number). Still further, a current flowing from the first external connection terminal $T_1$ to the connection point A is represented by a supply current $i_s$, a current flowing from the connection point A to the second external connection terminal $T_2$ by a load current $i_L$, and a current flowing from the connection point A to the semiconductor power converters 13 by a converter current $i_{HB}$. Regarding the voltages and the currents in the drawings, respective arrows point to positive directions.

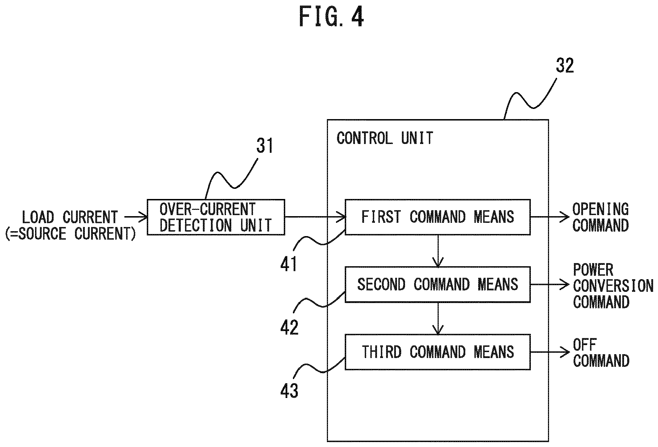

FIG. 4 is a block diagram explaining a control system in the circuit breaker according First Example. The circuit breaker 1 has a control system consisting of an over-current detection unit 31 and a control unit 32.

The over-current detection unit 31 detects whether or not an over-current has occurred on an external wire on the load side connected to the second external connection terminal $T_2$. Detection of the over-current generation can be carried out by any known method. For example, the occurrence of an accident such as ground fault and short circuit increases the supply current $i_s$, which is always monitored using a current detector (not illustrated), and when the supply current $i_s$ becomes larger by a certain value than a rated current, 'over-current occurred' is decided. The reference current value used for the decision of the over-current occurrence may be appropriately set as necessary, and it is, for example, 120% of the rated current.

The control unit 32 controls the opening operation of the mechanical circuit breaker 12 and the power conversion operation of the semiconductor power converters 13. In other words, the control unit 32 includes a first command means 41 for outputting, when the over-current detection unit 31 detects an over-current, an opening command commanding the mechanical breaker 12 to start its opening operation, a second command means 42 for outputting a power conversion command making the semiconductor power converters 13 output a direct current that makes converge to zero a current flowing through the mechanical breaker 12 during a period from the output of the opening command to the completion of the opening operation of the mechanical breaker 12, and a third command means 43 for outputting an off-command turning off the semiconductor switch S in each of the semiconductor power converters 13 upon the completion of the opening operation of the mechanical breaker 12.

The first command means 41, the second command means 42, and the third command means 43 may be made up, for example, of a software program, or may be made up of a combination of various electronic circuits and a software program. For example, when these means are made up of a software program, the function of each of the above-described means is achieved by a control unit operating in the control unit 32 according to the software program.

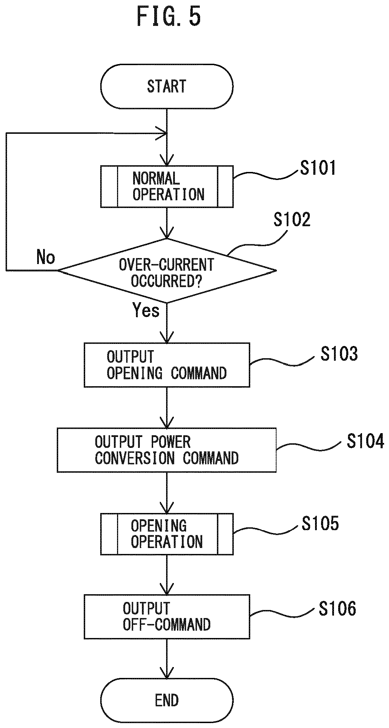

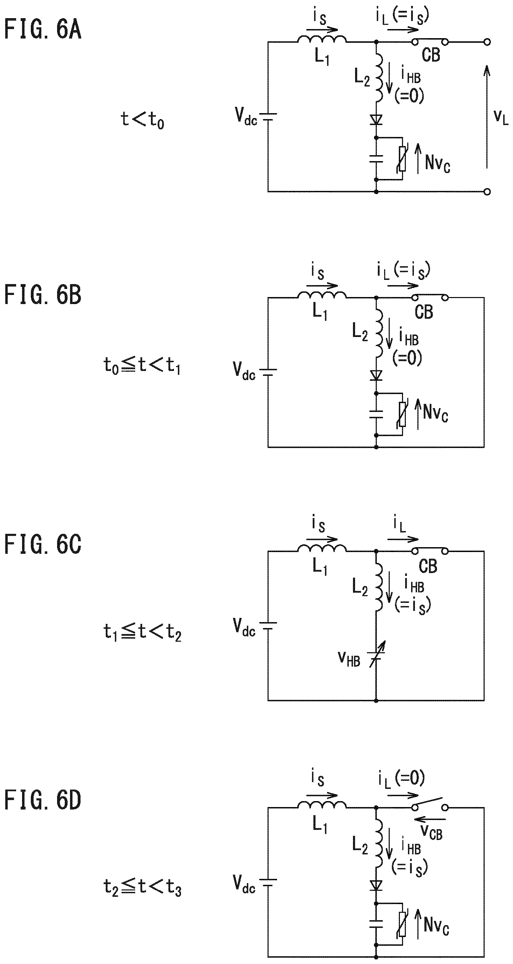

FIG. 5 is a flowchart illustrating an operational flow of the circuit breaker according to First Example. Further, FIGS. 6A to 6D are diagrams illustrating equivalent circuits explaining the operation of the circuit breaker according to First Example. Here, one example is considered in which an accidental ground fault or short circuit occurs on the load side and an over-current occurs at a time $t_0$.

The circuit breaker 1 is in normal operation while no over-current occurs on the load side (step S101). In other words, the mechanical circuit breaker 12 is turned on and electric power is supplied from the power supply side to the load side in normal operation. At this time, diodes D in each of the semiconductor power converters 13 function to make the semiconductor power converter 13 operate by itself as a diode, and thereby the converter current $i_{HB}$ becomes zero. Therefore, the steady loss of the circuit breaker 1 is zero in normal operation.

The DC voltage $V_{dc}$ on the power source side and the DC capacitor voltage $v_C$ (= $v_{C1}$ = $v_{CN}$) in each of the semiconductor power converters 13 desirably fulfill the following equation. The sign N indicates the number of semiconductor power converters 13 (in other words, number of DC capacitors).

[Math 1]

$$V_{dc} \leqslant N v_C \qquad \cdots (1)$$

As illustrated in FIG. 6A, the load current $i_L$ is equal to the supply current $i_S$, i.e., '$i_L = i_S$' in normal operation based on the Kirchhoff's current law. The load voltage $v_L$ is equal to the DC voltage $V_{dc}$ on the power source side, *i.e.*, '$v_L = V_{dc}$' because voltage drop in the first inductor $L_1$ is zero in normal operation.

In a step S102, the over-current detection unit 31 detects whether or not an over-current has occurred on an external wire on the load side connected to the second external connection terminal $T_2$. When the over-current detection unit 31 detects no over-current, the procedure returns to the step S101 and the normal operation is continued. When the over-current detection unit 31 detects an over-current, the procedure goes to a step S103.

For example, suppose that the over-current detection unit 31 detects the occurrence of an over-current at a time $t_1$, then an equivalent circuit of the circuit breaker 10 is expressed as in FIG. 6B, which is a circuit during a period from the time $t_0$ immediately after the occurrence of the accident on the load side to the time $t_1$. By ignoring the voltage drop in the mechanical circuit breaker 12, a circuit equation described by Equation 2 is fulfilled.

[Math 2]

$$V_{dc} - L_1 \frac{di_S}{dt} = 0 \qquad \cdots (2)$$

Based on Equation 2, the supply current $i_S$ and the load current $i_L$ are expressed by Equation 3. In Equation 3, $I_0$ represents a current at the time $t_0$.
[Math 3]

$$i_S = i_L = \frac{V_{dc}}{L_1}(t - t_0) + I_0 \qquad \cdots (3)$$

As can be seen from Equation 3, the supply current $i_S$ and the load current $i_L$ increase as a linear function having a slope of $[V_{dc}/L_1]$. In other words, increase in the inductance $L_1$ of the first inductor 11 can reduce the current increase rate upon the accident occurrence. The occurrence of an accidental short circuit or ground fault increases the supply current $i_S$, which is always monitored by the over-current detection unit 31 (not illustrated), and when the supply current $i_S$ becomes larger by a certain value than a rated current (e.g. 120% of the rated current), 'over-current occurred' is decided. A period '$t_1 - t_0$' required for the decision of the accident from the occurrence of an accident depends on parameters, such as the DC voltage $V_{dc}$ on the power supply side, the inductance $L_1$ of the first inductor, the load, and the reference current value.

When the over-current detection unit 31 detects an over-current in the step S102, the first command means of the control unit 32 outputs, in a step S103, an opening command commanding the mechanical circuit breaker 12 to start its opening operation.

Even when the opening command is sent to the mechanical circuit breaker 12, the breaker does not immediately complete its opening operation and a delay time occurs owing to its mechanical structure, resulting in slightly delayed completion of the opening operation. For example, a delay time of about 1 [ms] or less occurs for the DC voltage of several tens [kV] and that of about 2 [ms] for several hundreds [kV]. Since the mechanical circuit breaker 12 can interrupts a current path only when zero current flows therethrough, it is necessary to make zero the load current $i_L$ flowing through the mechanical circuit breaker 12. Therefore, in a step S104, the second command means 42 of the control unit 32 outputs a power conversion command making the semiconductor power converters 13 to output a direct current that makes converge to zero a current flowing through the mechanical circuit breaker 12 during the period from the output of the opening command to the completion of the opening operation of the mechanical circuit breaker 12. The semiconductor switching elements S of the semiconductor switches in the DCDC converter 21 in each of the semiconductor power converters 13 carry out the PWM switching operation on the basis of the received power conversion command. As a result, the group of semiconductor power converters 13 is equivalent to a control voltage source which operates to output $v_{HB}$, as illustrated in FIG. 6C. In FIG. 6C, a circuit equation described by Equation 4 is fulfilled.
[Math 4]

$$V_{dc} - L_1 \frac{di_S}{dt} = L_2 \frac{di_{HB}}{dt} + v_{HB} \qquad \cdots (4)$$

In First Example, the control voltage source is achieved, for example, by using the PI control, and $v_{HB}$ is given by Equation 5. In Equation 5, $K_p$ represents a proportional gain, $K_I$ an integrated gain, and $i^*_{HB}$ a commanded value of the converter current. Although the PI control is applied in this Example, a current control other than the PI control may be applied.
[Math 5]

$$v_{HB} = V_{dc} - L_1 \frac{di_S}{dt} - \left(K_P + K_I \int\right)(i^*_{HB} - i_{HB}) \qquad \cdots (5)$$

In Equation 5, the first and second terms on the right side correspond to the feedforward control, and the third term on the right side corresponds to the feedback control (PI). Substituting Equation 5 into Equation 4 results in Equation 6,
[Math 6]

$$\left(L_2 \frac{d^2}{dt^2} + K_P \frac{d}{dt} + K_I\right) i_{HB} = \left(K_P \frac{d}{dt} - K_I\right) i_{HB}^* \qquad \cdots (6)$$

As described in Equation 6, the converter current $i_{HB}$ responds, with second order delay, to the commanded value $i_{HB}^*$. At this time, the load current $i_L$ can be made zero by a control in which the commanded value of the converter current $i_{HB}^*$ is set to $i_S$ and the converter current $i_{HB}$ is made coincide with the supply current $i_S$. A time required to make the load current $i_L$ zero (i.e., time required to make the converter current $i_{HB}$ coincide with the supply current $i_S$) depends on the carrier frequency, the equivalent switching frequency, and the digital control method of the semiconductor power converters 13. For example, using a high voltage SiC MOSFET capable of operating with low loss and at high switching frequency can fully achieve the time of less than 1 [ms] required for making the load current $i_L$ zero.

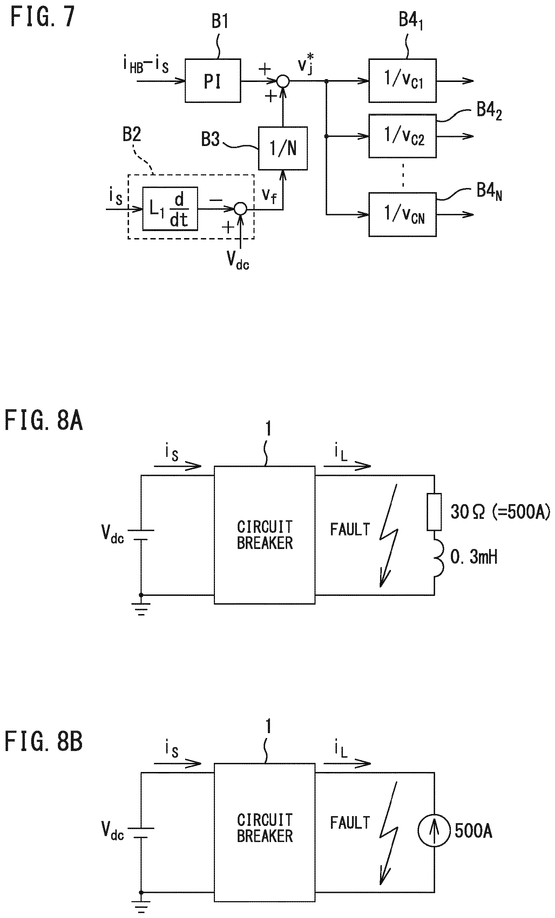

In view of the above, a principle to generate the power conversion command based on Equation 5 will be described as follows. FIG. 7 is a control block diagram explaining the power conversion command for controlling the converter current in the semiconductor power converters in the circuit breaker according to First Example. For controlling the converter current, the feedback control and the feedforward control are used in combination. The block B1 according to the feedback control applies the PI control to a difference between the power supply current $i_S$ detected by a current detector (not illustrated) and the converter current $i_{HB}$ detected by another current detector (not illustrated), to reduce the deviation '$i_{HB} - i_S$.' On the other hand, the block B2 according to the feedforward control uses the sum $v_f$ of the voltage $v_{HB}$ appearing across the semiconductor power converters 13 and a voltage appearing across the second inductor 14, to achieve improvement in current controllability. The voltage $v_f$ may be calculated from the voltage $V_{dc}$ on the DC power supply side, the supply current $i_S$, and the inductance $L_1$ of the first inductor 11, or directly detected by using a voltage sensor (not illustrated). The output from the block B1 and that from the block B3 are summed up to generate a power conversion command $v_j^*$ for each of the semiconductor power converters 13. The power conversion command $v_j^*$ for the semiconductor power converter 13 is normalized by a DC capacitor voltage $v_{Cj}$ (where $j$ = 1 to $N$) at the Block B4$_j$ and then given to semiconductor switches S in the semiconductor power converter 13 by using a general PWM modulation method (using triangular wave comparison). The equivalent switching frequency can be increased by applying a 'Phase shift PWM' method which shifts, by 180° / $N$, the initial phase of a triangular wave carrier to be used for the PWM control of each of the semiconductor power converters 13. Specifically, when the carrier frequency is $f_C$, the equivalent switching frequency is 2 $N$ $f_C$. Setting a high value for the equivalent switching frequency makes it possible to achieve the improvement of the current control system and the reduction of the inductance of the second inductor 14 as an inductor for current control.

In general, the switching frequency of semiconductor power converters for high voltage applications is set to several hundreds [Hz] from the viewpoint of reducing switching loss. On the other hand, the one or more semiconductor power converters 13 in the circuit breaker 1 according to First Example of the present invention carry out the PWM operation only upon the occurrence of an accident, and therefore, increase in switching loss is not problematic. When a SiC power module (SiC MOSFET and SiC SBD (Schottky Barrier Diode)) of, for example, 3.3 [kV] / 1,500 [A] is used for a semiconductor power converter 13, a carrier frequency of a several [kHz] is assumed to be applied to the PWM modulation, allowing improvement in the current controllability. When the carrier frequency is assumed to be the same, current controllability is improved for high voltage applications that lead to a larger number of cascade-connected semiconductor power converters 13.

As has been described above, the power conversion command is output in the step S104, but the procedure in the step S104 may be carried out simultaneously with the output of the opening command in the step S103.

Again with reference to FIG. 5, in the step S105 the mechanical circuit breaker 12 starts its opening operation in response to the opening command from the second command means 42 in the control section 32. The mechanical circuit breaker 12 can operate, as described above, only when zero current flows therethrough, and the procedure in the step S104 that makes zero a current flowing through the mechanical circuit breaker 12 is carried out within a sufficiently shorter period than that required from the output of the opening command to the completion of the opening operation of the mechanical circuit breaker 12.

When the opening operation of the mechanical circuit breaker 12 is completed (in this instance, it is at a time $t_2$), the third command means 43 in the control unit 32 outputs, in step the S106, a command turning off all the semiconductor switches S in each of the semiconductor power converters 13. The period '$t_2 - t_1$' required from the start of the power conversion operation of the semiconductor power converter 13 to the completion of the opening operation of the mechanical circuit breaker 12 is equal to a delay time taken from the transmission of the opening command to the mechanical circuit breaker 12 to the actual completion of the opening operation of the mechanical circuit breaker 12, and the period is, for example, 2 [ms].

Upon receiving the off-command from the third command means 43 in the control unit 32, all of the semiconductor switches S in the semiconductor power converter 13 are turned off, and thus the power conversion operation ends. As a result, only diodes D in the semiconductor power converter 13 will function, as illustrated in FIG. 6D. At this time, energies stored in the first inductor 11 and the second inductor 14 are released to the DC capacitor 22 and the nonlinear resistor 23 via the feedback diodes D. Since the DC capacitor 22 and the nonlinear resistor 23 are connected in parallel with each other, the DC capacitor 22 is charged, after the turn-off of the semiconductor switches S (*i.e.* period after time $t_2$), with energies stored in the first inductor 11 and the second inductor 14, leading to gradual increase in the voltage $v_C$, which is finally clamped at the operation voltage $V_R$ of the nonlinear resistor 23. After the DC capacitor 22 is charged up to the operation voltage, the stored energies are consumed by the nonlinear resistor 23.

A circuit equations described by Equation 7 are fulfilled until the DC capacitor 22 is charged with the stored energies up to the operation voltage of the nonlinear resistor 23.

[Math 7]

$$V_{dc} - L_1 \frac{di_S}{dt} = L_2 \frac{di_{HB}}{dt} + N v_C$$
$$v_C = \frac{1}{C} \int i_{HB} = \frac{1}{C} \int i_S \qquad \cdots (7)$$
$$i_{HB} = i_S$$

On the basis of Equation 7, the voltage $v_C$ of the DC capacitor 22 and the supply current $i_S$ (= $i_{HB}$) can be calculated by solving a second order linear differential equation with constant coefficients.

After the DC capacitor 22 was charged up to the operation voltage, a circuit equation described in Equation 8 is fulfilled. In Equation 8, the operation voltage of the nonlinear resistor 23 is defined as $V_R$.

[Math 8]

$$V_{dc} - L_1 \frac{di_S}{dt} = L_2 \frac{di_{HB}}{dt} + N V_R \qquad \cdots (8)$$
$$i_{HB} = i_S$$

On the basis of Equation 8, the supply current $i_S$ and the converter current $i_{HB}$ can be calculated by solving a first order linear differential equation with constant coefficients.

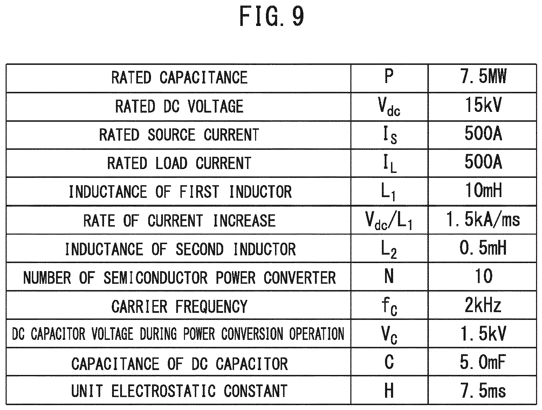

Next, simulation results of the circuit breaker according to First Example will be described. FIG. 8A illustrates a circuit diagram used for the simulation of the circuit breaker according to First Example, which is a circuit diagram for the circuit breaker, with an RL load connected thereto, upon the occurrence of an accidental short circuit in the close vicinity of the ends of the circuit breaker. FIG. 8B illustrates a circuit diagram used for the simulation of the circuit breaker according to First Example, which is a circuit diagram for the circuit breaker, with a regenerative load connected thereto, upon occurrence of an accidental short circuit in the close vicinity of the ends of the circuit breaker. In FIG. 8B, the regenerative load is simulated by a DC source. Further, FIG. 9 is a table listing circuit parameters for the simulation circuit diagrams illustrated in FIG. 8A and FIG. 8B. A simulator 'PSCAD/EMTDC' was used for the simulation. Under an assumption of high voltage applications, the rated capacity P was set to 7.5 MW, the rated DC voltage $V_{dc}$ to 15 [kV], the rated power supply current $I_S$ to 500 [A], and the rated load current $I_L$ to 500 [A]. The inductance $L_1$ of the first inductor (inductor for limiting current upon the occurrence of an accident) was set to 10 [mH] so that the current increase rate $V_{dc} / L_1$ might be 1.5 [kA/ms]. In addition, under an assumption of a semiconductor switching element having a breakdown voltage of 3.3 [kV], the initial DC capacitor voltage was set to 1.5 [kV], the number $N$ of semiconductor power converters 13 to 10, and the carrier frequency $f_C$ to 2 [kHz]. The unit electrostatic constant H is a value (unit: [s]) of the total electrostatic energy of the DC capacitor normalized by the converter capacity and can be expressed by Equation 9,

[Math 9]

$$H = \frac{\frac{1}{2} C V_C^2 N}{P} \qquad \cdots (9)$$

In the simulation, the dead time of the semiconductor switching element was assumed to be zero under an assumption of an analog control system having a zero control delay. Further, a reference current value used for the decision of the occurrence of over-current was set to 120% of the rated current. Still further, the nonlinear resistor 23 was assumed to be a resistor which had an operation voltage set to 2 [kV], and exhibited an infinite resistance value for the applied voltage of 2 [kV] or less, and zero for 2 [kV] or more. Still further, the mechanical circuit breaker 12 was simulated as an ideal switch having a zero impedance, and the delay time was set to 1.5 [ms], which was a period from receiving the opening command to the completion of the opening operation (= $t_2 - t_1$) .

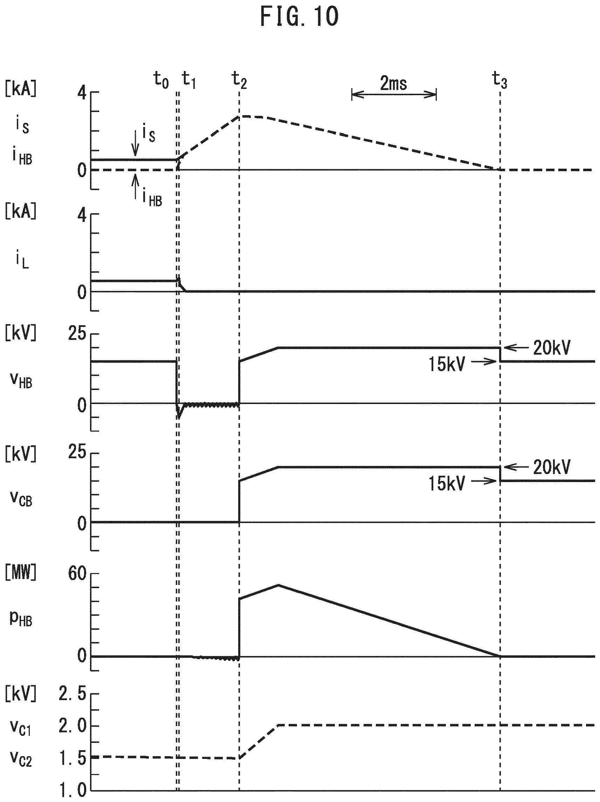

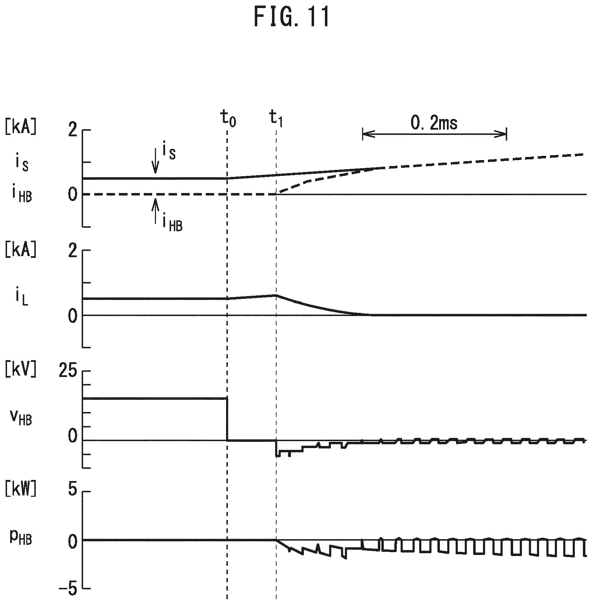

FIG. 10 is a diagram indicating a simulated waveform for the circuit breaker according to First Example made operate on the simulation circuit of FIG. 8A. Further, FIG. 11 is a diagram indicating the waveform of FIG. 10 enlarged on the time axis. In FIG. 11, the voltage $v_{CB}$ appearing across the mechanical circuit breaker 12 and the DC capacitor voltage were omitted. An example will be considered in which an accidental short circuit occurs at a time $t_0$, in the close vicinity of the ends of the circuit breaker 1, with an RL load (7.5 [MW]) connected to the circuit breaker 1.

Diodes D in each semiconductor power converter 13 before the time $t_0$ when the accidental short circuit occurs functions to make the semiconductor power converter 13 operate by itself as a diode. In this case, the load current $i_L$ is 500 [A] which is the same as the value of supply current $i_S$, resulting in the converter current $i_{HB}$ of 0 [A] from the Kirchhoff's current law. Therefore, the power supply voltage $V_{dc}$ on the direct current side becomes equal to the converter voltage $v_{EB}$, and both of them are 15 [kV]. Meanwhile, the DC capacitor 22 in each of the semiconductor power converters 13 is charged up to a voltage ($V_{dc}$ / $N$) of 1.5 [kV].

When the accidental short circuit occurs at the time $t_0$, the supply current $i_S$ and the converter current $i_L$ increase as a linear function with a slope of 1.5 [kA/ms] (= $V_{dc}$ / $L_x$). The supply current $i_S$ and the load current $i_L$ reach 600 [A] (i.e., 120% of rated current) in a period of about 70 [μs]. The converter voltage $v_{HB}$ is reduced to zero on the basis of Equation 2, Equation 4, and a relation of '$i_{HB}$ = 0.'

At the time $t_1$, an opening command is given to the mechanical circuit breaker 12. At the same time, a power conversion command is output which makes the semiconductor power converter 13 output a direct current that reduces a current flowing through the mechanical circuit breaker 12 to zero. As a result, semiconductor switches S in the semiconductor power converter 13 carry out the PWM switching operation on the basis of the received power conversion command. As illustrated in FIG. 11, the load current $i_L$ is zero at 0.35 [ms] after the application of the current control, and the mechanical circuit breaker 12 is brought into a state capable of interrupting the current path. The converter voltage $v_{HB}$ immediately after the time $t_1$ is a negative voltage. As illustrated in FIG. 11, the converter voltage $v_{HB}$ drops to -5 [kV]. This amount of voltage drop depends on not only the amount of the deviation between the converter current $i_{HB}$ and the supply current $i_S$ but also a control gain value. At this time, the DC voltages $v_{C1}$ and $v_{C2}$ of the DC capacitors 22 in the semiconductor power converters 13 decrease owing to power output from the semiconductor power converters 13. This amount of decrease can be reduced by a shorter period '$t_2 - t_1$' from the start of the PWM operation and the reception of the opening command to the completion of the opening of the mechanical breaker 12. For this simulation, the period '$t_2 - t_1$' was set to 1.5 [ms].

At the time $t_2$, the opening operation of the mechanical circuit breaker 12 is completed, and at the same time the semiconductor switching elements S of all of the semiconductor switches in the DCDC converter 21 in each of the semiconductor power converters 13 is turned off. The DC voltages $v_{C1}$ and $v_{C2}$ of the DC capacitors 22 increase up to the operation voltage of the nonlinear resistors 23 (2.0 [kV]) according to the circuit equations of Equation 7. Then, supply current $i_S$ and converter current $i_{HB}$ decrease linearly according to the circuit equations of Equation 8. From Equation 8, a current variation rate is described by Equation 10.

[Math 10]

$$\frac{di_S}{dt} = \frac{di_{HB}}{dt} = \frac{V_{dc} - NV_R}{L_1 + L_2} \qquad \cdots (10)$$

Substituting circuit constants in FIG. 9 into Equation 10 results in a current variation rate of -0.5 [kA/ms], which is consistent with the simulation result in FIG. 10. In this instance, $V_R$ was set to 2 [kV], which value was the operation voltage of the nonlinear resistor 23.

On the other hand, the voltage $v_{CB}$ appearing across the mechanical circuit breaker 12 is described by Equation 11 based on FIG. 1 and Equation 10.

[Math 11]

$$v_{CB} = V_{dc} - L_1 \frac{di_S}{dt} = V_{dc} + \frac{L_1(NV_R - V_{dc})}{L_1 + L_2} \qquad \cdots (11)$$

Substituting the circuit constants in FIG. 9 and the operation voltage $V_R$ = 2 [kV] of the nonlinear resistor 23 into Equation 11 results in the voltage $v_{CB}$ appearing across the mechanical circuit breaker 12 of 20 [kV], which value is consistent with the simulation result in FIG. 10. As can be understood from Equation 11, the voltage $v_{CB}$ appearing across the mechanical circuit breaker 12 can be reduced by bringing '$N V_R$ - $V_{dc}$' close to zero, but the power consumption by the nonlinear resistor 23 increases because the current reduction rate decreases. Since the supply current $i_S$ is zero after a time $t_3$, ' $v_{CB} = V_{dc} = 15$ [kV]' is fulfilled from Equation 11. According to this simulation result, the period ' $t_3 - t_0$' required from the occurrence of the accidental short circuit to the completion of the current interruption is 7.7 [ms], which shows that the circuit breaker 1 can achieve fast current interruption.

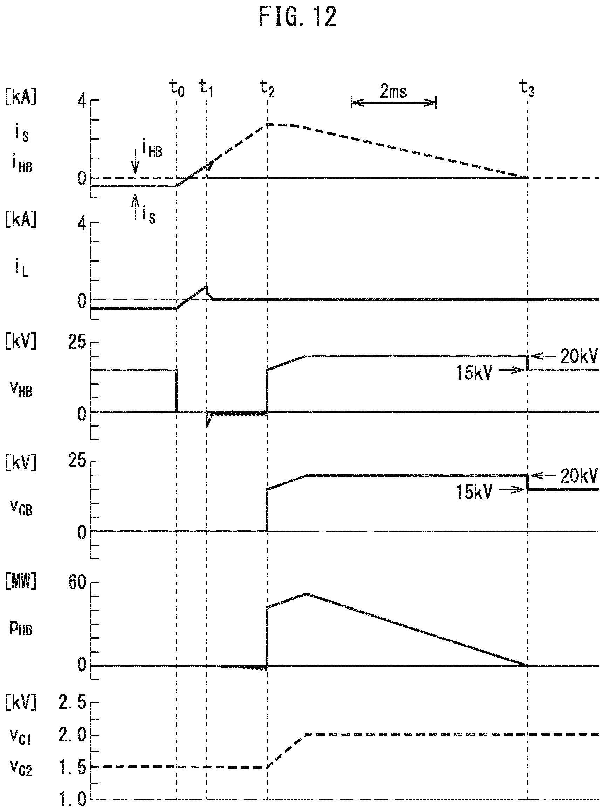

FIG. 12 is a diagram indicating a simulated waveform for the circuit breaker according to First Example made operate on the simulation circuit of FIG. 8B. An example will be considered in which an accidental short circuit occurs at a time $t_0$ in the close vicinity of the ends of the circuit breaker 1, with a regenerative load (7.5 [MW]) connected to the circuit breaker 1.

Since this simulation is based on the regenerative load, both the supply current $i_S$ and the load current $i_L$ are -500 [A] in normal operation at a time before the time $t_0$ when an accidental short circuit occurs. The period ' $t_1 - t_0$' required from the occurrence of the accident at the time $t_0$ to the detection of the accident is 680 [$\mu$s]. The waveforms for the respective quantities are the same as those in FIG. 10. According to this simulation result, the period ' $t_3 - t_0$' required from the occurrence of the accidental short circuit to the completion of the current interruption is 8.3 [ms], which shows that the circuit breaker 1 can achieve fast current interruption.

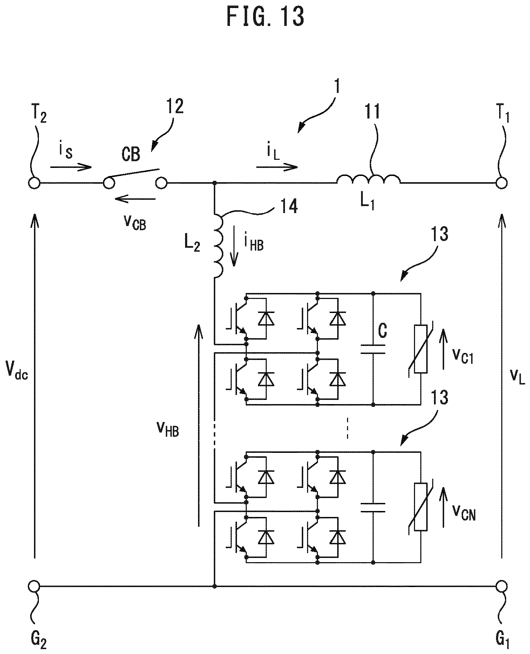

In First Example described above, it is assumed that the circuit breaker 1 is placed on a DC power supply system so that the first inductor 11 and the mechanical circuit breaker 12 may be on the power supply side and on the load side, respectively, but as a variation example, the connection of the circuit breaker 1 may be changed from the power supply side to the load side. FIG. 13 is a circuit diagram illustrating a variation example of the circuit breaker according to First Example.

As illustrated in FIG. 13, the variation of First Example assumes that the circuit breaker 1 is placed on the DC power supply system so that the first inductor 11 and the mechanical circuit breaker 12 may be on the load side and on the power supply side, respectively. In other words, a circuit on the load side and a circuit on the power supply side are connected to the first external connection terminal $T_1$ of the first inductor 11 and the second external connection terminal $T_2$ of the mechanical circuit breaker 12, respectively. This variation example is the same as First Example described with reference to FIG. 1 to FIG. 7 except that the connection relation of the power supply side and the load side with reference to the circuit breaker 1 is reversed. In other words, the respective configurations of the first inductor 11, the mechanical circuit breaker 12, the one or more semiconductor power converters 13, and the second inductor 14, and the control system in this variation are the same as in First Example.

A description will be made for a simulation result of the circuit breaker in the variation of First Example. A simulation circuit was used in which the circuit breaker 1 illustrated in FIG. 8A and FIG. 8B was replaced with the circuit breaker 1 in the variation example. The nonlinear resistor 23 in the circuit parameters used for the simulation was assumed to be a resistor which operated at an operation voltage of 2 [kV] and exhibited an infinite resistance value for the applied voltage of 2 [kV] or less and zero for the voltage of more than 2 [kV], in order to prevent over-modulation of the DCDC converter 21. The other circuit parameters were those listed in FIG. 9 used for the simulation of First Example described above. Further, times such as the time of the accident occurrence and that of the application of the current control system were the same as those in First Example described above.

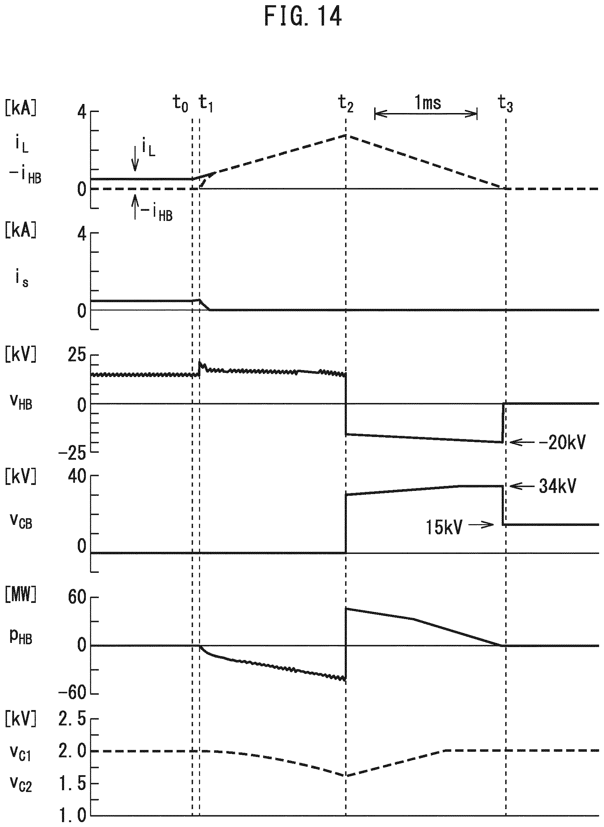

FIG. 14 is a diagram indicating a simulated waveform for the circuit breaker according to the variation of First Example made operate on the simulation circuit in FIG. 8A. An example will be considered in which an accidental short circuit occurs at the time $t_0$ in the close vicinity of the ends of the circuit breaker 1, with an RL load (7.5 [MW]) connected to the circuit breaker 1.

As described above, in order to prevent the over-modulation of the DCDC converter 21 in each of the semiconductor power converters 13, the voltage $v_C$ of the DC capacitor 22 is desirably 2 [kV] even in normal operation before the time $t_0$ when the accidental short circuit occurs. Specifically, by applying the PWM control to the DCDC converter 21, the voltage is boosted from 1.5 [kV] in the diode operation which is an operation mode of the semiconductor power converter 13 in normal operation, to 2 [kV]. As illustrated in FIG. 14, the supply current $i_S$ and the converter current $v_{HB}$ each includes a switching ripple component superimposed thereon. Power consumed by the semiconductor power converter 13 corresponds to power required for achieving constant-voltage control of the DC capacitors 22 and is sufficiently smaller than the load power. Therefore, loss caused by the PWM control can be ignored. Each of the DCDC converters 21 performs the PWM operation immediately also after the occurrence of the accident (from time $t_C$ to time $t_1$), and achieves $V_C = 2$ [kV].

An opening command is given to the mechanical circuit breaker 12 at the time $t_1$. At the same time, a power conversion command is output which makes the semiconductor power converter 13 output a direct current that makes converge to zero a current flowing through the mechanical circuit breaker 12. Specifically, the deviation between the load-side current $i_L$ and the converter current $-i_{HB}$ is controlled to be zero, and thereby the supply current $i_S$ becomes zero. Thus, the mechanical circuit breaker 12 can be made carry out the current interruption operation.

When the simulation result of First Example illustrated by FIG. 10 is compared with that of this variation example illustrated by FIG. 14, the fluctuation width of the converter power $p_{HB}$ during the period from $t_1$ to $t_2$ is larger in the circuit breaker 1 according to this variation example. This is attributed to a fact that the converter voltage $v_{HB}$ in the circuit breaker 1 according to First Example is a value near zero, whereas that according to this variation example is a value near the power supply voltage $V_{dc}$ (15 [kV]). As a result, the extent of decrease in the DC capacitor voltage in the circuit breaker 1 according to this variation example is larger than that according to First Example. At the time $t_2$, the opening operation of the mechanical circuit breaker 12 is completed and at the same time, all of the semiconductor switches are turned off. When the simulation result of First Example illustrated by FIG. 10 is compared with that of this variation example illustrated by FIG. 14, the circuit breaker 1 according to First Example makes $i_L$ (= - $i_{HB}$) converge to zero more rapidly. The current variation rate in the circuit breaker 1 according to this variation example can be described by Equation 12.

[Math 12]

$$\frac{di_L}{dt} = -\frac{di_{HB}}{dt} = \frac{-NV_R}{L_1 + L_2} \qquad \cdots (12)$$

Substituting the circuit constants listed in FIG. 9 and $v_C$ = 2 [kV] into Equation 12 results in a current variation rate of -2 [kA/ms], which value is consistent with the simulation result indicating - 3 [kA] per 1.5 [ms].

On the other hand, the converter voltage $v_{HB}$ after the completion of the opening operation of the mechanical circuit breakers 12 can be described by Equation 13 based on FIG. 13 and Equation 12.

[Math 13]

$$v_{HB} = (L_1 + L_2)\frac{di_L}{dt} \qquad \cdots (13)$$
$$= -NV_R$$

Substituting $N$ = 10 and $V_R$ = 2 [kV] into Equation 13 results in a converter voltage $v_{HB}$ = -20 [kV], which value is consistent with the simulation result. At this time, the voltage $v_{CB}$ appearing across the mechanical circuit breaker 12 can be described by Equation 14 based on FIG. 13. In this derivation, the voltage drop across the second inductor 14 was set to zero.

[Math 14]

$$v_{CB} \simeq V_{dc} - v_{HB} \qquad \cdots (14)$$

Substituting $V_{dc}$ = 15 [kV] and $v_{HB}$ = -20 [kV] into Equation 14 results in $v_{CB}$ = 35 kV, which value is consistent with the simulation result. Since the converter voltage $v_{HB}$ is zero after the time $t_3$, the voltage $v_{CB}$ appearing across the mechanical circuit breaker 12 is 15 [kV] from Equation 14. According to this simulation result, the period '$t_3$ - $t_0$' required from the occurrence of the accidental short circuit to the completion of the current interruption is 3 [ms], which shows that faster current interruption can be achieved than in the circuit breaker 1 according to First Example.

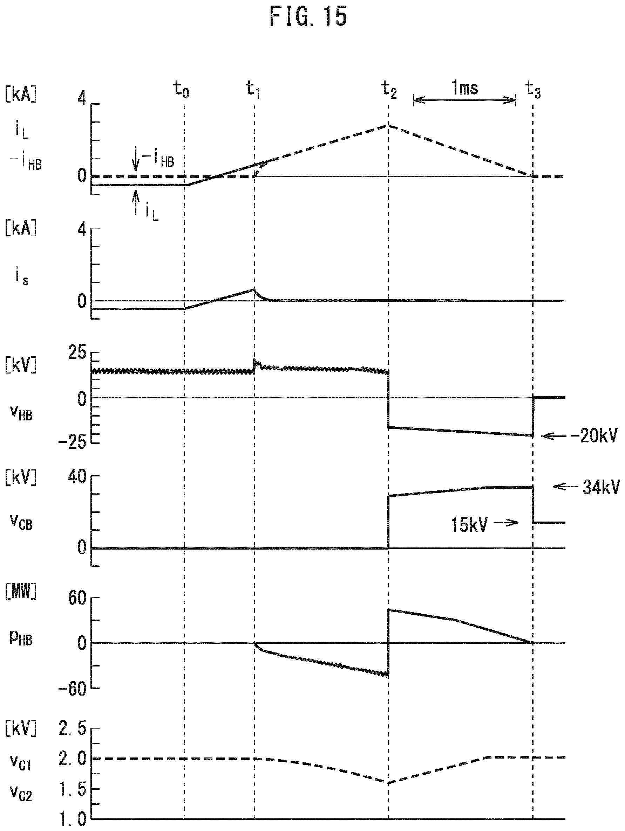

FIG. 15 is a diagram indicating a simulated waveform for the circuit breaker according to the variation of the First Example made operate on the simulation circuit in FIG. 8B. An example will be considered in which an accidental short circuit occurs at the time of $t_0$ in the close vicinity of the ends of the circuit breaker 1, with a regenerative load (7.5 [MW]) connected to the circuit breaker 1. As illustrated in FIG. 15, the waveforms for the respective quantities are the same as those in the case of the RL load. According to this simulation result, the period '$t_3$ - $t_0$' required from the occurrence of the short circuit accident to the completion of the current interruption is 3.7 [ms], which shows that fast current interruption can be achieved.

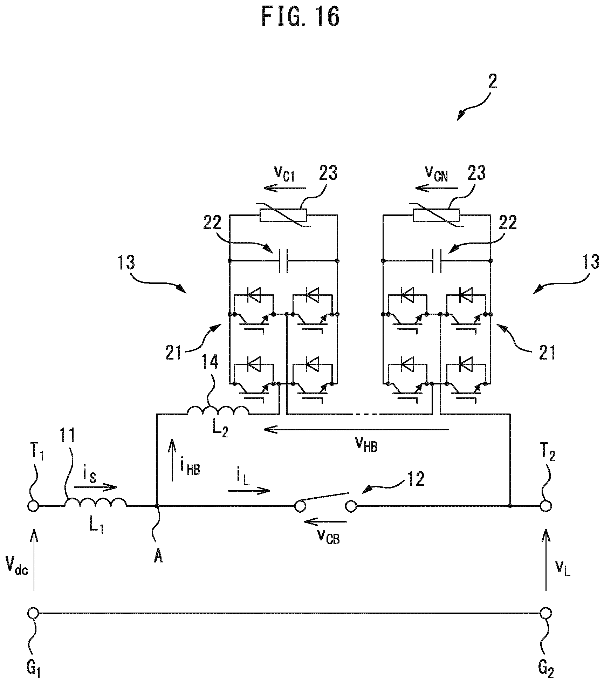

Next, Second Example, this Second Example now being an example of the present invention will be described. FIG. 16 is a circuit diagram explaining a semiconductor power converter in a circuit breaker according to Second Example. The circuit breaker 1 according to First Example described above was placed so that one or more semiconductor power converters 13 might be connected in parallel with an applied DC power supply system, but the circuit breaker 2 according to Second Example is placed so that the one or more semiconductor power converters 13 might be connected in series with the DC power supply system. The circuit breaker 2 according to Second Example is provided with a first inductor 11, a mechanical circuit breaker 12, one or more semiconductor power converters 13, and a second inductor 14, as with the case of First Example.

The first inductor 11 has a first external connection terminal $T_1$ at one end thereof. The first external connection terminal $T_1$ is connected to a circuit on the power supply side. The configuration of the first inductor 11 is the same as that explained in First Example.

The mechanical circuit breaker 12 is connected in series with the first inductor 11, and has a second external

connection terminal $T_2$ on one side thereof opposite to the other side thereof connected to the first inductor 11. The second external connection terminal $T_2$ is connected to a circuit on the load side. The configuration of the mechanical breaker 12 is the same as that explained in First Example.

The one or more semiconductor power converters 13 are provided, singly or in a form of cascade-connection with each other, on a wire branching from a wire that connects the first inductor 11 to the mechanical circuit breaker 12. As with the case of First Example, when a single semiconductor power converter 13 is used, a side thereof connected to the second inductor 14 is referred to as the 'first DC side', and when a plurality of semiconductor power converters 13 are cascade-connected with each other, a side of the semiconductor power converter 13 connected to another semiconductor power converter 13 different therefrom is also referred to as the 'first DC side.' Further, the other DC side opposite to the 'first DC side' is referred to as the 'second DC side.' FIG. 16 illustrates an example in which a plurality of semiconductor power converters 13 (N converters, where N is an integer of 2 or more) are cascade-connected with each other on the first DC side. The configuration of the semiconductor power converters 13 is the same as that explained in First Example. However, when the energy storage unit 22 in each of the semiconductor power converters 13 is a DC capacitor, an initial charging circuit (not illustrated) is desirably provided separately, unlike the case of First Example.

In Second Example, the second inductor 14 is connected in series with the semiconductor power converters 13. As with the case of First Example, when the plurality of semiconductor power converters 13 are cascade-connected with each other, the second inductor 14 is connected, as illustrated in FIGS. 3A to 3C, in series with any one of the semiconductor power converters 13 cascade-connected with each other, and when a single semiconductor power converter 13 is used, the second inductor 14 is simply connected in series with the semiconductor power converter 13.

Whether the plurality of semiconductor power converters 13 are cascade-connected or a single semiconductor power converter 13 is used, the second inductor 14 is provided at any position on the same wire to which the one or more semiconductor power converters 13 are connected. In Second Example, the one or more semiconductor power converters 13 and the second inductor 14 both placed on the same wire configure a unit connected in parallel with the mechanical circuit breaker 12.

In Second Example, ground terminals $G_1$ and $G_2$ are provided, which correspond to the first external connection terminal $T_1$ and the second external connection terminal $T_2$, respectively. The circuit breaker 2 can operate as an AC breaker as well as a DC circuit breaker, and in this case, the terminals $G_1$ and $G_2$ are terminals having a polarity opposite to that of the first external connection terminal $T_1$ and the second external connection terminal $T_2$.

When the circuit breaker 1 operates as an AC breaker, the DCDC converter 21 in each of the semiconductor power converters 13 operates as a DCAC converter (Direct Current-Alternating Current converter). The DC side of the DCAC converter corresponds to the above-mentioned 'second DC side', and the AC side thereof corresponds to the above-mentioned 'first DC side.'

In the example illustrated in FIG. 16, the side including the first external connection terminal $T_1$ and the ground terminal $G_1$ is determined to be the power supply side and the side including the second external connection terminal $T_2$ and the ground terminal $G_2$ is determined to be the load side. Therefore, the first inductor 11 functions as an inductor for limiting an accidental current, and the second inductor 14 functions as an inductor for current control.

In this instance, the DC voltage on the power supply side is represented by $V_{dc}$, the load voltage by $v_L$, the voltage appearing across the mechanical circuit breaker 12 by $v_{CB}$, the total voltage across the cascade-connected semiconductor power converters 13 by $v_{HB}$. Further, the voltage of a DC capacitor connected in parallel with each of the semiconductor power converters 13 is represented by $v_{C1}...$ or $v_{CN}$. Still further, a current flowing from the first external connection terminal $T_1$ to the first inductor 11 is represented by the supply current $i_S$, a current flowing from the connection point A to the second external connection terminal $T_2$ by the load current $i_L$, and a current flowing from the connection point A to the semiconductor power converters 13 by the converter current $i_{HB}$. Regarding voltages and currents in the drawings, respective arrows point to positive directions.

The circuit breaker 2 according to Second Example also operates in the same manner as that of the operation flow of the circuit breaker 1 according to First Example described with reference to FIG. 5. In other words, an accidental ground fault or short circuit occurs on the load side and causes an over-current at a time $t_0$, and then at a time $t_1$, an opening command is given to the mechanical circuit breaker 12, and at the same time the DCDC converter 21 in each of the semiconductor power converters 13 is made start its power conversion operation. Further, as soon as the opening operation of the mechanical circuit breaker 12 is completed at the time $t_2$, all semiconductor switches S are turned off, and at a time $t_3$ the supply current $i_S$ and the converter current $i_{HB}$ become zero, and thus, the current interruption is completed. A more detailed description is made as follows.

The operation of the circuit breaker 2 in normal operation before the time $t_0$ when the accidental short circuit occurs is the same as that of the circuit breaker 1 according to the First Example. In other words, the mechanical circuit breaker 12 is turned on in normal operation, and power is supplied from the power supply side to the load side. At this time, diodes D in each of the semiconductor power converters 13 function to make the semiconductor power converter 13 operate by itself as a diode, and thereby the converter current $i_{HB}$ becomes zero and the supply current $i_S$ becomes equal to the load current $i_L$. Unlike the case of First Example, the DC voltage $V_{dc}$ on the power source side and the DC capacitor voltage $v_C$ (= $v_{C1}$ = $v_{CN}$) in each of the semiconductor power converters 13 may not fulfill the relation of Equation 1.

The operation of the circuit breaker 2 immediately after the detection of the over-current occurrence by the detection unit 31 at the time $t_1$ is also the same as that of the circuit breaker 1 according to First Example. As expressed in Equation 3, the supply current $i_S$ and the load current $i_L$ increase as a linear function having a slope of '$V_{dc}/L_1$.'

The operation of the semiconductor power converters 13 in the circuit breaker 2 during the period from the time $t_1$ to the time $t_2$ is also the same as that in First Example. However, the control system for the converter current in the semiconductor power converters is different from that in First Example. This will be described later.

The operation of the circuit breaker 2 at the time $t_2$ when the opening operation of the mechanical circuit breaker 12 is completed is also the same as that of the circuit breaker 1 according to First Example. In other words, all of the semiconductor switching elements S in the DCDC converter 21 in each of the semiconductor power converters 13 are turned off, and thereby the energies stored in the first inductor 11 and the second inductor 14 are released to the DC capacitor 22 and the nonlinear resistor 23 via the feedback diodes D. Voltage equations and current relations to be fulfilled in this period are the same as those in First Example.

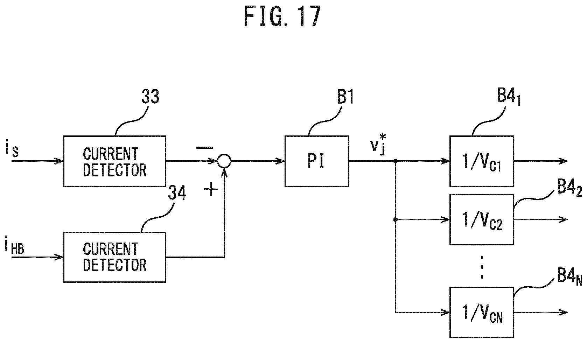

Now, the control system for the converter current in the semiconductor power converters will be explained. FIG. 17 is a control block diagram explaining a power conversion command for controlling converter current in the semiconductor power converters in the circuit breaker according to Second Example. In Second Example, the load current $i_L$ is made zero by a control in which the converter current $i_{HB}$ is made coincide with the supply current $i_S$, by applying the generation principle of the power conversion command for controlling the converter current, as with First Example described with reference to FIG. 7. However, the block B2 involved in the feedforward control in First Example illustrated in FIG. 7 is not used, but only the block B1 involved in the feedback control is used as illustrated in FIG. 17. The block B1 involved in the feedback control reduces the deviation '$i_{HB}$ - $i_S$' by applying the PI-control to the difference between the converter current $i_{HB}$ and the power supply current $i_S$. As an alternative for this control, the deviation '$i_{HB}$ - $i_S$' may be reduced by applying the P-control to the difference between the converter current $i_{HB}$ and the power supply current $i_S$. A power conversion command $v_j^*$ (where $j$ = 1 to $N$) for each of the semiconductor power converters 13 is generated in the block B1. The power conversion command $v_j^*$ for the semiconductor power converter 13 is normalized by a DC capacitor voltage $v_{Cj}$ (where $j$ = 1 to N) at the Block B4$_j$ and then given to semiconductor switches S in the semiconductor power converter 13 by using a general PWM modulation method (using triangular wave comparison). As with the case with First Example, the equivalent switching frequency can be increased by applying a 'Phase shift PWM' method which shifts, by 180° / $N$, the initial phase of a triangular wave carrier to be used for the PWM control of each of the semiconductor power converters 13. Specifically, when the carrier frequency is $f_C$, the equivalent switching frequency is 2 $N f_C$. Setting a high value for the equivalent switching frequency makes it possible to achieve the improvement of the current control system and the reduction of the inductance of the second inductor 14 as an inductor for current control.

Now, a more detailed description will be made for a current detector provided for controlling the converter current. As illustrated in FIG. 17, a current detector 33 is provided for detecting the supply current $i_S$, and another current detector 34 is provided for detecting the converter current $i_{HB}$. The maximum value of the current detection range of the current detectors 33 and 34 is equal to that of an accidental current to be interrupted. Therefore, the detection error of the current detectors 33 and 34 may adversely affect the current control system described with reference to FIG. 17. In general, the accidental current to be interrupted is set to 5 to 10 times as large as a current in normal operation. For example, when the supply current in normal operation $i_S$ is assumed to be 500 [A] and the accidental current to be interrupted be 10 times as large as the value of the supply current, the current detectors 33 and 34 are desirably able to detect a current of 5,000 [A] at a maximum. On the other hand, the current detectors always have a detection error. For example, when the detection error of each of the current detectors 33 and 34 is assumed to be 1%, it means that an error as large as 50 [A] occurs in the current detectors 33 and 34, which error may adversely affect the current control system described with reference to FIG. 17. In view of the above, the current detectors may be configured as in a first or second variation example described below.

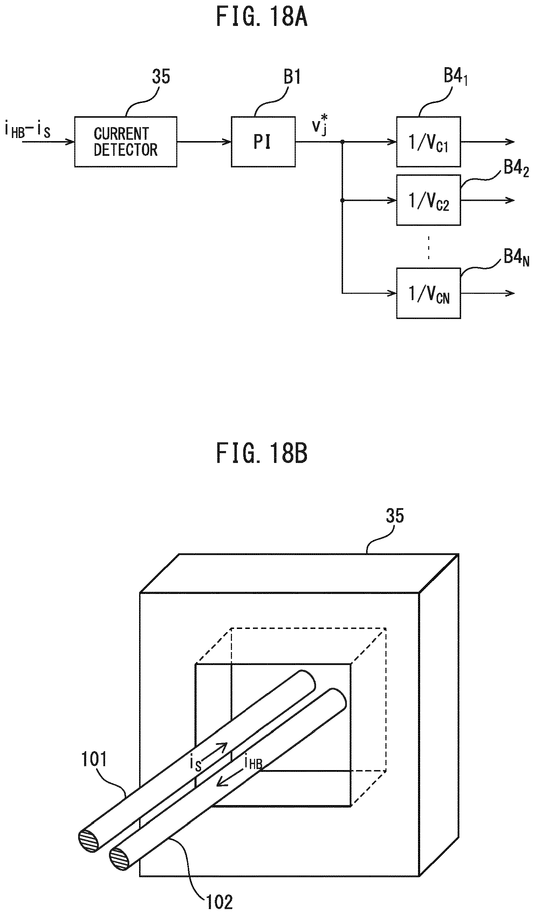

FIG. 18A is a block diagram explaining a first variation example of a current detector used for controlling the converter current in the semiconductor power converters in the circuit breaker according to Second Example. FIG. 18B is a diagram exemplifying the current detector according to the first variation example illustrated in FIG. 18A. In the first variation example, the difference '$i_{HB}$ - $i_S$' between the converter current $i_{HB}$ and the power supply current $i_S$ is detected directly by a current detector 35 as illustrated in FIG. 18A, rather than the supply current $i_S$ and the converter current $i_{HB}$ are detected by the separate current detectors 33 and 34 as illustrated in FIG. 17. For example, as illustrated in FIG. 18B, a conducting wire 101 (*i.e.* conducting wire connecting the first external connection terminal T$_1$ and the connection point A) through which the supply current $i_S$ flows and a conducting wire 102 (*i.e.* conducting wire connecting the connection point A and the semiconductor power converters 13) through which the converter current $i_{HB}$ flows may be input into the current detector 35 so that the flowing direction of converter current $i_{HB}$ may be anti-parallel with that of the supply current $i_S$. The current detector 35 may be a well-known detector by itself.

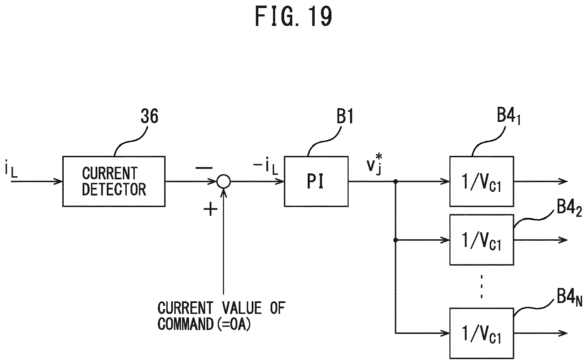

FIG. 19 is a block diagram illustrating a second variation example of the current detector used for controlling the converter current in the semiconductor power converters in the circuit breaker according to Second Example. In the second variation example, the load current $i_L$ flowing from the connection point A to the second external connection terminal $T_2$ (*i.e.* circuit breaker current flowing through the mechanical circuit breaker 12) is detected by using a current detector 36 as illustrated in FIG. 19, rather than the supply current $i_S$ and the converter current $i_{HB}$ are detected by the separate current detectors 33 and 34 as illustrated in FIG. 17. Then, in order to achieve the feedback control of the load current $i_L$ (PI-control or P-control) by a block B1, '0 [A]' is added to the block B1 as a commanded current value. In FIG. 16, an Equation 15 is fulfilled based on the Kirchhoff's current law.

[Math 15]

$$i_S = i_L + i_{HB} \qquad \cdots (15)$$

When the detection error of the current detectors 35 and 36 is ignored, Equation 15 means the equivalence of the current detector 35 illustrated in FIG. 18A to the current detector 36 illustrated in FIG. 19. Therefore, the first variation example (FIG. 18A) and the second variation example (FIG. 19) can be expected to exert comparable current-reducing effects.

According to the above first and second variation examples, the number of current detectors necessary for controlling the converter current $i_{HB}$ can be reduced from 2 to 1, as compared with the control system illustrated in FIG. 17, thus yielding an advantage of achieving cost reduction.

According to the above first and second variation examples, the current detection range of the current detectors can be reduced, and as a result, these examples have an advantage of reducing the influence of the detection error of the current detectors, as compared with the control system illustrated in FIG. 17. A description will be made for this error reduction by taking the current detector 35 illustrated in FIG. 18A as an example. For example, when the supply current $i_S$ is 600 [A] at a time when the over-current detection unit 31 detects the occurrence of an over-current, i.e., at a time of $t_1$, the maximum value of the current detection range of the current detector 35 is '$i_{HB}$ - $i_S$' which is a value immediately after the detection of the over-current occurrence. The reason is that after detecting the over-current occurrence, the feedback control acts so as to reduce to zero the difference '$i_{HB}$ - $i_S$' between the converter current $i_{HB}$ and the power supply current $i_S$. Since the converter current $i_{HB}$ is 0 [A] and supply current $i_S$ is 600 [A] immediately after the detection of the over-current occurrence, the maximum value of the current detection range of the current detector 35 is 600 [A] which is a value of the power supply current immediately after the detection of the over-current occurrence. In other words, in the control system illustrated in FIG. 17 the current detectors 33 and 34 are required to detect an accidental current to be interrupted (5 to 10 times as large as the supply current in normal operation), whereas the current detection range of the current detector 35 illustrated in FIG. 18A is comparable to the supply current $i_S$ immediately after the detection of the over-current occurrence. As a result, the influence of detection error of the current detector 35 can be reduced to 1/5 to 1/10. For example, when the accidental current to be interrupted is set to 5,000 [A] which is ten times as large as the supply current $i_S$ in normal operation and the detection error of the current detector 35 is assumed to be 1%, the control system illustrated in FIG. 17 has a detection error of 50 [A] (i.e., 5,000 [A] × 1%), whereas the detection error of the current detector 35 illustrated in FIG. 18A is 6 [A] (600 [A] × 1%). Since the control system illustrated in FIG. 17 requires two current detectors, the maximum detection error is 100 [A] (50 [A] × 2). In the second variation example illustrated in FIG. 18A, the current detection range of the current detector 36 is equal to the supply current $i_S$ immediately after the detection of the over-current occurrence, from the Kirchhoff's current law, as described above. Therefore, the influence of the detection error of the current detector in FIG. 18A is comparable to that in FIG. 19.

Thus, according to the first and second variation examples, the current detection error is smaller than in the control system illustrated in FIG. 17, and therefore, more precise current control can be achieved. As a result, improvement in the performance of the circuit breaker 2 is expected. In general, the larger the current detection range is, the more costly current detectors are. According to the first and second variation examples, since the current detectors may only work within a detection range of a current comparable to the power supply current immediately after the detection of the over-current occurrence, cost reduction for single current detectors can also be achieved in contrast to the control system illustrated in FIG. 17.

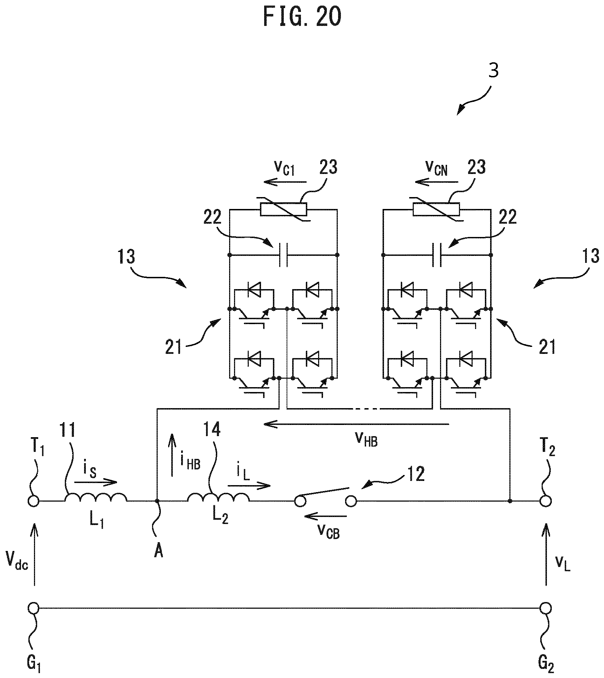

Next, Third Example, this Third Example being also an example of the present invention, will be described. FIG. 20 is a circuit diagram explaining a semiconductor power converter in the circuit breaker according to Third Example. The circuit breaker 3 according to Third Example is placed so that one or more semiconductor power converters 13 are connected in series with the DC power supply system as with the case of Second Example, but Third Example differs from Second Example in that the one or more semiconductor power converters 13 are connected in parallel with a series circuit configured by a mechanical circuit breaker 12 and a second inductor 14. In other words, in the circuit breaker 3 according to Third Example, the one or more semiconductor power converters 13 are connected in parallel with a unit configured by the mechanical circuit breaker 12 and the second inductor 14 connected in series with each other. Either of the mechanical circuit breaker 12 or the second inductor 14 may be placed on the load side so long as the mechanical circuit breaker 12 and the second inductor 14 are connected in series with each other.

The first inductor 11 has a first external connection terminal $T_1$ at one end thereof. The first external connection terminal $T_1$ is connected to a circuit on the power supply side. The configuration of the first inductor 11 is the same as that described in First and Second Examples.

In Third Example, the second inductor 14 is connected in series with the mechanical circuit breaker 12. In other words, in Third Example, a unit is configured by the mechanical circuit breaker 12 and the second inductor 14 both placed on the same wire. A second external connection terminal $T_2$ is connected on one side of the unit opposite to the side thereof connected to the first inductor 11. The second external connection terminal $T_2$ is connected to a circuit on the load side. The configuration of the mechanical circuit breaker 12 and the second inductor other than the above is the same as those described in First Example and Second Examples.

The one or more semiconductor power converters 13 are provided, singly or in a form of cascade-connection to each other, on a wire branching from a wire that connects the first inductor 11 to the unit configured by the mechanical circuit breaker 12 and the second inductor 14 both placed on the same wire. In other words, in Third Example, the one or more semiconductor power converters 13 are connected in parallel with the unit configured by the mechanical circuit breaker 12 and the second inductor 14 connected in series with each other. The definitions of 'first DC side' and 'second DC side' are the same as those in First and Second Examples. An example is illustrated in FIG. 20 in which a plurality of semiconductor power converters 13 (N converters, where N is an integer of 2 or more) are cascade-connected with each other on the first DC side. The configuration of the semiconductor power converters 13 is the same as that explained in First and Second Examples. However, when the energy storage unit 22 in each of the semiconductor power converters 13 is a DC capacitor, it is necessary to provide an initial charging circuit (not illustrated) separately, unlike the case of First Example.

In Third Example, ground terminals $G_1$ and $G_2$ are provided corresponding to the first external connection terminal $T_1$ and the second external connection terminal $T_2$, respectively. The circuit breaker 3 can operate also as an AC breaker as well as a DC circuit breaker, and the ground terminals $G_1$ and $G_2$ are terminals having a polarity opposite to that of the first external connection terminal $T_1$ and the second external connection terminal $T_2$.

When the circuit breaker 1 operates as an AC breaker, the DCDC converter 21 in each of the semiconductor power converters 13 operates as a DCAC converter (Direct Current-Alternating Current converter). In this case, the DC side of the DCAC converter corresponds to the above-mentioned 'second DC side', and the AC side thereof corresponds to the above-mentioned 'first DC side.'

In the example illustrated in FIG. 20, the side including the first external connection terminal $T_1$ and the ground terminal $G_1$ is determined to be a power supply side, and the side including the second external connection terminal $T_2$ and the ground terminal $G_2$ is determined to be a load side. Accordingly, the first inductor 11 functions as an inductor for limiting an accidental current, and the second inductor 14 functions as an inductor for current control.

In this instance, the DC voltage on the power supply side is represented by $V_{dc}$, the load voltage by $v_L$, the voltage appearing across the mechanical circuit breaker 12 by $v_{CB}$, and the total voltage across the cascade-connected semiconductor power converters 13 by $v_{HB}$. Further, the voltage of the DC capacitor connected in parallel with each of the semiconductor power converter 13 is represented by $v_{C1}$ ... or $v_{CN}$. Still further, a current flowing from the first external connection terminal $T_1$ to the first inductor 11 is represented by a supply current $i_S$, a current flowing from the connection point A to the second external connection terminal $T_2$ by a load current $i_L$, and a current flowing from the connection point A to the semiconductor power converters 13 by the converter current $i_{HB}$. Regarding voltages and currents in the drawings, respective arrows point to positive directions.

The control system of the circuit breaker 3 according to Third Example has the same configuration as that of the control system of the circuit breaker 2 according to Second Example described with reference to FIG. 17, FIG. 18A, FIG. 18B, and FIG. 19. Under this control system, the circuit breaker 3 according to Third Example also operates in the same manner as that of the operation flow of the circuit breaker 1 according to First Example described with reference to FIG. 5. In other words, an accidental ground fault or short circuit occurs on the load side and causes an over-current at the time $t_0$, and then at the time $t_1$, an opening command is given to the mechanical circuit breaker 12, and at the same time the DCDC converter 21 in the semiconductor power converter 13 is made start the power conversion operation. Further, as soon as the opening operation of the mechanical circuit breaker 12 is completed at the time $t_2$, all semiconductor switches S are turned off and the supply current $i_S$ and the converter current $i_{HB}$ become zero at the time $t_3$, and thus, the current interruption is completed. A more detailed description for the operation will be made as follows.

The operation of the circuit breaker 3 in normal operation before the time $t_0$ when an accidental short circuit occurs is the same as that of the circuit breaker 1 according to First Example. In other words, the mechanical circuit breaker 12 is turned on in normal operation, and power is supplied from the power supply side to the load side. At this time, diodes D in each of the semiconductor power converters 13 function to make the semiconductor power converter 13 operate by itself as a diode, and thereby the converter current $i_{HB}$ becomes zero and the supply current $i_S$ becomes equal to the load current $i_L$. Unlike the case of First Example, the DC voltage $V_{dc}$ on the power source side and the DC capacitor voltage $v_C$ (= $v_{C1}$ = $v_{CN}$) in each of the semiconductor power converters 13 may not fulfill the relation of Equation 1.

The operation of the circuit breaker 3 immediately after the over-current occurrence by the over-current detection unit 31 at the time $t_0$ is also the same as that of the circuit breaker 1 according to First Example. As expressed by Equation 3, the supply current $i_S$ and the load current $i_L$ increase as a linear function having a slope of '$V_{dc}$ / $L_1$.' However, the influence of the second inductor 14 is ignored.

The operation of the circuit breaker 3 during the period between time $t_1$ and time $t_2$ is also the same as that of the circuit breaker 2 according to Second Example. In other words, the load current $i_L$ is made zero by a control in which the converter current $i_{HB}$ is made coincide with the supply current $i_S$, by applying the generation principle of the power conversion command for controlling the converter current described with reference to FIG. 17, FIG. 18A, FIG. 18B, and FIG. 19.

The operation of the circuit breaker 3 at the time $t_2$ when the opening operation of the mechanical circuit breaker 12 is completed is also the same as that of the circuit breaker 1 according to First Example. In other words, all of the semiconductor switching elements S in the DCDC converter 21 in each of the semiconductor power converters 13 are turned off, and thereby the energies stored in the first inductor 11 and the second inductor 14 are released to the DC capacitor 22 and the nonlinear resistor 23 via the feedback diodes D. Voltage equations and current relations to be fulfilled during this period are the same as those in First Example.

The energy storage unit 22 of Second Example and Third Example was configured by a single DC capacitor, and further, a variation example of the energy storage unit 22 thereof will be described as follows. Hereinafter, a description will be made for the energy storage unit 22 of Second Example, but it is also applicable to the energy storage unit 22 of Third Example.

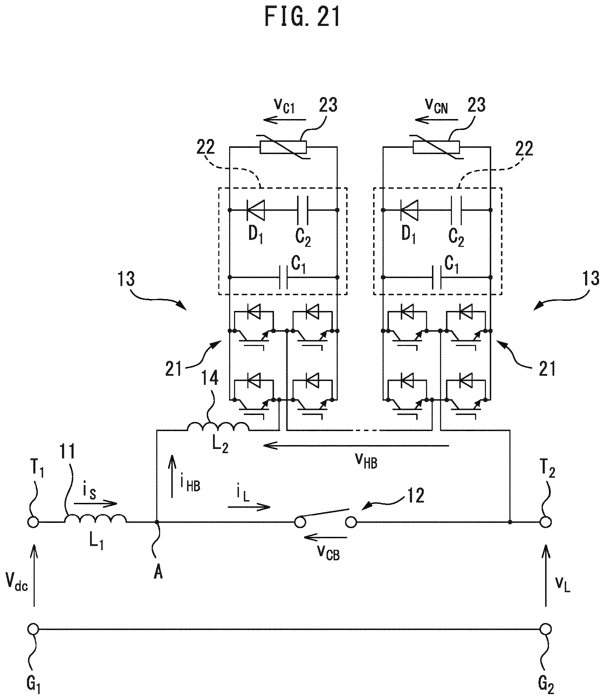

FIG. 21 is a circuit diagram explaining a first variation example of the energy storage unit in the semiconductor power converter in the circuit breaker according to Second Example.

According to the first variation example, the energy storage unit 22 includes a snubber capacitor $C_1$ which is a first capacitor connected in parallel with a nonlinear resistor 23, a discharge capacitor $C_2$ which is a second capacitor having a larger capacitance and a lower charge voltage than those of the snubber capacitor $C_1$, and a reverse current-blocking diode $D_1$ which is connected in series with the discharge capacitor $C_2$ and interrupts a current flowing into the discharge capacitor $C_2$. The discharge capacitor $C_2$ and the reverse current-blocking diode $D_1$ configure a series circuit connected in parallel with the snubber capacitor $C_1$.

In this way, the first variation example is an energy storage unit including a single DC capacitor (corresponding to the snubber capacitor $C_1$ in FIG. 21) that is the energy storage unit 22 illustrated in FIG. 16 and a series circuit connected in parallel therewith, which circuit is configured by the discharge capacitor $C_2$ and the reverse current-blocking diode $D_1$. Thus, the capacitance of the snubber capacitor $C_1$ can be used, irrespective of the capacitance of the discharge capacitor $C_2$, only for an original function of decreasing surge voltage, enabling significant miniaturization of the energy storage unit 22 illustrated in FIG. 16, as compared with the unit configured by a single DC capacitor. For example, the discharge capacitor $C_2$ may have a capacitance set to 125 [mF] and a charge voltage set to 50 [V] and a snubber capacitor $C_1$ may have a capacitance set to 10 [μF] and a charge voltage set to 4,400 [V].

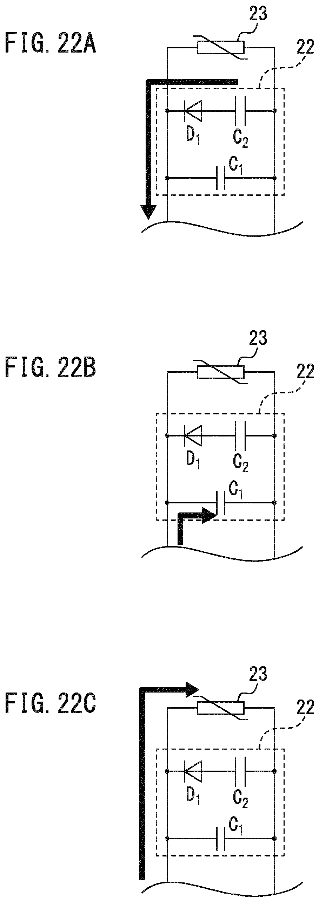

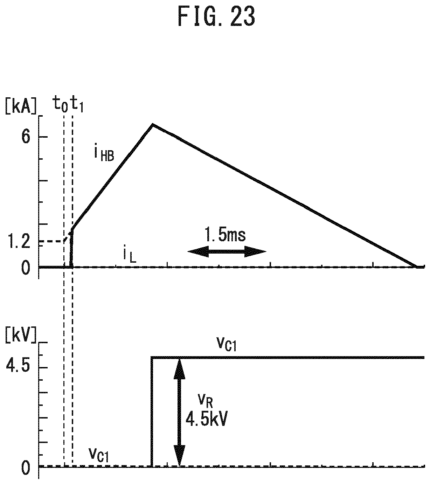

FIG. 22A to FIG. 22C are circuit diagrams illustrating the operation of the energy storage unit illustrated in FIG. 21. In the FIG. 22A to FIG. 22C, only the energy storage unit 22 and the nonlinear resistor 23 in a semiconductor power converter 13 are illustrated for simplicity of explanation. Further, FIG. 23 is a diagram indicating a simulated waveform for the circuit breaker illustrated in FIG. 21 during its operation. In this simulation, the circuit breaker illustrated in FIG. 21 included a discharge capacitor $C_2$ having a capacitance set to 125 [mF] and a charge voltage set to 50 [V] and a snubber capacitor $C_1$ having a capacitance set to 10 [μF] and a charge voltage set to 4,400 [V]. Further the circuit breaker illustrated in FIG. 16 included an energy storage unit 22 including a DC capacitor having a capacitance set to 10 [μF].

Since in Second Example and Third Example as described above the energy storage unit 22 in the semiconductor power converter 13 is configured by DC capacitors (i. e., the snubber capacitor $C_1$ and the discharge capacitor $C_2$), the units are charged in advance by an initial charging circuit (not illustrated). In other words, in the circuit breaker 2 in normal operation before the time $t_0$ when an accidental short circuit occurs, the mechanical circuit breaker 12 is turned on and power is supplied from the power supply side to the load side. In this case, diodes D in each of the semiconductor power converters 13 function to make the semiconductor power converter 13 operate by itself as a diode, and thereby the converter current $i_{HB}$ becomes zero and the supply current $i_S$ becomes equal to the load current $i_L$. In this case, the voltages of both the snubber capacitor $C_1$ and the discharge capacitor $C_2$ are a value of the voltage precharged by the initial charging circuit.

Immediately after detection of the over-current occurrence by the detection unit 31 at the time $t_0$, the supply current $i_S$ and the load current $i_L$ increase as a linear function having a slope of '$V_{dc}$ / $L_1$' as illustrated in Equation 3. The over-current detection unit 31 decides 'over-current occurred' when the supply current $i_S$ becomes larger than a rated current by a certain value (for example, 120% of the rated current). Then, the first command means 41 of the control unit 32 outputs the opening command commanding the mechanical circuit breaker 12 to start its opening operation. As mentioned above, even when the opening command is given to the mechanical circuit breaker 12, it does not immediately complete its opening operation but practically completes the opening operation with a slight delay time. For example, a delay time of 1 [ms] or less occurs for a DC voltage of several tens [kV] and about 2 [ms] for several hundreds [kV]. Since the mechanical circuit breaker 12 can interrupts a current path only when zero current flows, the load current $i_L$ flowing through the mechanical circuit breaker 12 is desirably zero.

Therefore, the second command means 42 of the control unit 32 outputs a power conversion command that makes the semiconductor power converters 13 output a direct current that makes converge to zero a current flowing through the mechanical breaker 12 during a period from the output of the opening command to the completion of the opening operation of the mechanical breaker 12. The semiconductor switching elements S of the semiconductor switches in the DCDC converter 21 in each of the semiconductor power converters 13 carry out the PWM switching operation on the basis of the received power conversion command. As a result, the energy stored in the discharge capacitor $C_2$ in the energy storage unit 22 is converted, by the DCDC converter 21 as illustrated in FIG. 22A, into a direct current that is output to make converge to zero a current flowing from the semiconductor power converters 13 to the mechanical circuit breaker 12. In FIG. 22A, the thick arrow indicates the energy flow released from the discharge capacitor $C_2$.

When the opening operation of the mechanical circuit breaker 12 is completed, the third command means 43 in the control unit 32 outputs a command turning off all the semiconductor switches S in the semiconductor power converters 13. Upon receiving the off-command sent by the third command means 43 in the control unit 32, all of the semiconductor switches S in the semiconductor power converter 13 are turned off, and thus, the power conversion operation is completed. As a result, only diodes D in the semiconductor power converter 13 function. In this instance, as illustrated in FIG. 22B, the energies stored in the first inductor 11 and the second inductor 14 are released to the snubber capacitor $C_1$ via the feedback diodes D, thereby gradually increasing the voltage of the snubber capacitor $C_1$. In FIG. 22B, the thick arrow indicates the energy flow from the first inductor 11 and the second inductor 14 to the snubber capacitor $C_1$. When the voltage of the snubber capacitor $C_1$ becomes larger than the voltage of the discharge capacitor $C_2$, the reverse current-blocking diode $D_1$ prevents a charging current from flowing into the discharge capacitor $C_2$, thereby enabling disconnecting the discharge capacitor $C_2$ from the second DC side of the DCDC converter 21 electrically. Since the capacitance of the snubber capacitor $C_1$ is smaller than that of the discharge capacitor $C_2$, the voltage of the snubber capacitor $C_1$ rapidly rises as illustrated by FIG. 23.

When the voltage of the snubber capacitor $C_1$ increases up to the operation voltage $V_R$ of the nonlinear resistor 23, the energies stored in the first inductor 11 and the second inductor 14 are consumed by the nonlinear resistor 23 as illustrated in FIG. 22C. In FIG. 22B, the thick arrow indicates the energy flow from the first inductor 11 and the second inductor 14 to the nonlinear resistor 23. Since the voltage of the snubber capacitor $C_1$ rapidly rises as described above, a time required for the voltage to reach the operation voltage $V_R$ of the nonlinear resistor 23 can be significantly shortened as compared with FIG. 16, and as a result, the time required for current interruption can be drastically shortened.

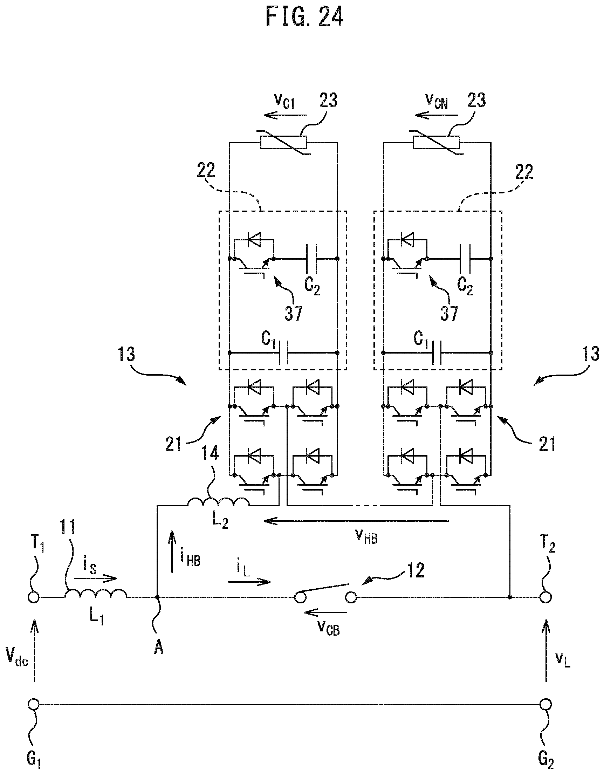

FIG. 24 is a circuit diagram explaining a second variation example of the energy storage unit in the semiconductor power converter in the circuit breaker according to Second Example.

According to the second variation example, the energy storage unit 22 includes a snubber capacitor $C_1$ which is a first capacitor connected in parallel with the nonlinear resistor 23, a discharge capacitor $C_2$ which is a second capacitor having a larger capacitance and a lower charge voltage than those of the snubber capacitor $C_1$, and a semiconductor valve device 37 which is connected in series with the discharge capacitor $C_2$ and controls a charging current flowing into the discharge capacitor $C_2$ in response to a command. The discharge capacitor $C_2$ and the semiconductor valve device 37 configure a series circuit connected in parallel with the snubber capacitor $C_1$. The semiconductor valve device 37 has a semiconductor switching element allowing, when turned on, a current to flow unidirectionally and a feedback diode connected in anti-parallel with the semiconductor switching element. Examples of the semiconductor switching element in the semiconductor valve device 37 includes an IGBT, a thyristor, a GTO (Gate Turn-Off thyristor), and a transistor, but the type of the switching element does not limit by itself the present invention and other semiconductor elements may be used.

Thus, the second variation example is an energy storage unit provided with a semiconductor valve device 37 in place of the reverse current-blocking diode $D_1$ in the first variation example. The semiconductor power converter 13 is made output a direct current that makes converge to zero a current flowing to the mechanical circuit breaker 12 during a period from the output of the opening command to the completion of the opening operation of the mechanical circuit breaker 12, and a charging current may flow in the direction opposite to the energy flow illustrated in FIG. 22A during this period, depending on an operational condition. In the first variation example, the reverse current-blocking diode $D_1$ prevents such a charging current flow, which causes a voltage increase in the snubber capacitor $C_1$. On the other hand, in the second variation example, an on-signal is given to the switching element in the semiconductor valve device 37 so that the reverse charging current may flow into the discharge capacitor $C_2$, thereby reducing the voltage increase of the snubber capacitor $C_1$ that occurs in the first variation example. As a result, the desired capacitance of the snubber

capacitor $C_1$ can be further reduced as compared with the first variation example, thereby enabling further cost reduction and miniaturization of the circuit breaker.

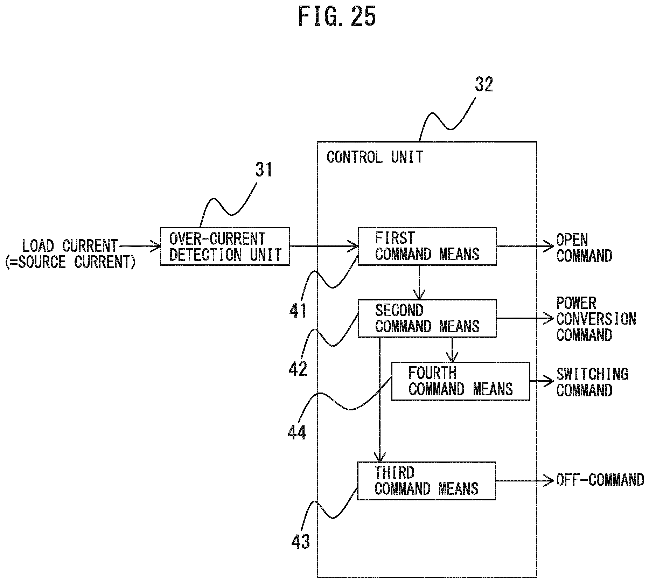

FIG. 25 is a block diagram explaining a control system in the circuit breaker illustrated in FIG. 24. The control unit 32 controls the opening operation of the mechanical circuit breaker 12, the operation of power conversion of the DCDC converter 13 in each of the semiconductor power converters 13, and the on-off operation of the semiconductor switching element in the semiconductor valve device 37. In other words, the control unit 32 includes a first command means 41 for outputting an opening command commanding the mechanical circuit breaker 12 to start its opening operation when the over-current detection unit 31 detects an over-current, a second command means 42 for outputting a power conversion command making the semiconductor power converter 13 output a direct current that makes converge to zero a current flowing through the mechanical circuit breaker 12 during a period from the output of the opening command to the completion of the opening operation of the mechanical circuit breaker 12, a third command means 43 for outputting a command turning off the semiconductor switches S in each of the semiconductor power converter 13 upon the completion of the opening operation of the mechanical circuit breaker 12, and a fourth command means 44 for outputting a switching command turning on the semiconductor switching element in the semiconductor valve device 37 while the second command means 42 outputs the power conversion command to the DCDC converter 21 and otherwise turning off the semiconductor switching element in the semiconductor valve device 37.

The above first and second variation examples were described for the energy storage unit 22 in Second Example, but the examples are also applicable to the energy storage unit 22 in Third Example.

Reference Signs List

> 1, 2, 3 circuit breaker
> 11 first inductor
> 12 mechanical breaker
> 13 semiconductor power converter
> 14 second inductor
> S semiconductor switch
> $T_1$ first external connection terminal
> $T_2$ second external connection terminal
> 21 DCDC converter
> 22 energy storage unit
> 23 nonlinear resistor
> 31 over-current detection unit
> 32 control unit
> 33, 34, 35, 36 current detector
> 37 semiconductor valve device
> 41 first command means
> 42 second command means
> 43 third command means
> 44 fourth command means

**Claims**

1. A circuit breaker (2) comprising:

> a first inductor (11) comprising a first external connection terminal ($T_1$);
> a mechanical breaker (12) being connected in series to the first inductor (11) and comprising a second external connection terminal ($T_2$) on one side thereof opposite to the other side thereof connected to the first inductor (11), which mechanical breaker (12) is opened to interrupt a current path in response to a command;
> one or more semiconductor power converters (13) which are provided singly or in a form cascade-connected with each other on a wire branching from a wire connecting the first inductor (11) to the mechanical breaker (12), and output a certain direct current by making a semiconductor switch (S) provided in each of the one or more semiconductor power converters (13) carry out a switching-operation in response to a command; and
> a second inductor (14) connected in series with the one or more semiconductor power converters (13); wherein the one or more semiconductor power converters (13) comprise:

a DCDC converter (21) converting a direct current input from one of a first DC side and a second DC side into a direct current of a desired magnitude and polarity and outputting the current to the other side by the switching operation of the semiconductor switch (S), which DCDC converter (21) can switch an input-output direction of the direct current bidirectionally between the first and second DC sides;

an energy storage unit (22) connected in parallel with the second DC side opposite to the first DC side connected to the second inductor (14) or another semiconductor power converter different from the semiconductor power converter (13); and

a nonlinear resistor (23) connected in parallel with the energy storage unit (22), which resistor exhibits a certain resistance value when a DC voltage applied to the energy storage unit (22) is equal to or lower than a preset voltage, and otherwise exhibits a resistance value lower than the certain resistance value, wherein the energy storage unit (22) comprises:

a first capacitor ($C_1$) connected in parallel with the nonlinear resistor (23);

a second capacitor ($C_2$) having a larger capacitance and a lower charging voltage than those of the first capacitor ($C_1$); and

a semiconductor valve device (37) being connected in series with the second capacitor ($C_2$) and controlling, in response to a command, a charging current flowing into the second capacitor ($C_2$), which device comprises a semiconductor switching element allowing, when turned on, a current to flow unidirectionally and a feedback diode connected in anti-parallel with the semiconductor switching element, wherein the one or more semiconductor power converters (13) and the second inductor (14) both placed on the same wire configure a unit connected in parallel with the mechanical breaker, wherein the second capacitor ($C_2$) and the semiconductor valve device (37) configure a series circuit connected in parallel with the first capacitor ($C_1$).

2. A circuit breaker (3) comprising:

a first inductor (11) comprising a first external connection terminal ($T_1$); a second inductor (14) being connected in series to the first inductor (11);

a mechanical breaker (12) being connected in series to the second inductor (14) and comprising a second external connection terminal ($T_2$) on one side thereof opposite to the other side thereof connected to the second inductor (14), which mechanical breaker (12) is opened to interrupt a current path in response to a command;

one or more semiconductor power converters (13) which are provided singly or in a form cascade-connected with each other on a wire branching from a wire connecting the first inductor (11) to the second inductor (14), and output a certain direct current by making a semiconductor switch (S) provided in each of the one or more semiconductor power converters (13) carry out a switching-operation in response to a command; and

wherein each of the one or more semiconductor power converters (13) comprises:

a DCDC converter (21) converting a direct current input from one of a first DC side and a second DC side into a direct current of a desired magnitude and polarity and outputting the current to the other side by the switching operation of the semiconductor switch (S), which DCDC converter (21) can switch an input-output direction of the direct current bidirectionally between the first and second DC sides;

an energy storage unit (22) connected in parallel with the second DC side opposite to the first DC side connected to the second inductor (14) or another semiconductor power converter different from the semiconductor power converter (13); and

a nonlinear resistor (23) connected in parallel with the energy storage unit (22), which resistor exhibits a certain resistance value when a DC voltage applied to the energy storage unit (22) is equal to or lower than a preset voltage, and otherwise exhibits a resistance value lower than the certain resistance value, wherein the energy storage unit (22) comprises:

a first capacitor ($C_1$) connected in parallel with the nonlinear resistor (23);

a second capacitor ($C_2$) having a larger capacitance and a lower charging voltage than those of the first capacitor ($C_1$); and

a semiconductor valve device (37) being connected in series with the second capacitor ($C_2$) and controlling, in response to a command, a charging current flowing into the second capacitor ($C_2$), which device comprises a semiconductor switching element allowing, when turned on, a current to flow unidirectionally and a feedback diode connected in anti-parallel with the semiconductor switching element, wherein the one or more semiconductor power converters (13) are connected in parallel with the unit comprising the second inductor (14) and the mechanical breaker (12) connected in series with each other, wherein the second capacitor ($C_2$) and the semiconductor valve device (37) configure a series circuit connected in parallel with the first

capacitor ($C_1$).

3. The circuit breaker (2, 3) according to any one of claim 1 or 2, comprising:

an over-current detection unit detecting whether or not an over-current has occurred on an external wire connected to the first or second external connection terminal ($T_1$, $T_2$); and
a control unit (32) controlling the opening operation of the mechanical breaker (12), the power conversion operation of the DCDC converter (21) in the one or more semiconductor power converters (13), and the on-off operation of the semiconductor switching element in the semiconductor valve device (37), wherein the control unit (32) comprises
a first command means (41) for outputting, when the over-current detection unit detects an over-current, an opening command commanding the mechanical breaker (12) to start the opening operation,
a second command means (42) for outputting a power conversion command making the DCDC converter (21) in the one or more semiconductor power converters (13) output a direct current that makes converge to zero a current flowing through the mechanical breaker (12) during a period from the output of the opening command to the completion of the opening operation of the mechanical breaker (12),
a third command means (43) for outputting an off-command turning off the semiconductor switch (S) in the one or more semiconductor power converters (13) upon the completion of the opening operation of the mechanical circuit breaker (1, 2, 3), and
a fourth command means (44) for outputting a switching command turning on the semiconductor switching element in the semiconductor valve device (37) while the second command means (42) outputs the power conversion command to the DCDC converter (21), and otherwise turning off the semiconductor switch element in the semiconductor valve device (37).

4. The circuit breaker (2, 3) according to any one of the preceding claims, wherein the semiconductor switch (S) comprises:

a semiconductor switching element, when turned on, allowing a current to flow unidirectionally; and
a feedback diode connected in anti-parallel with the semiconductor switching element.

5. The circuit breaker (2, 3) according to any one of the preceding claims, wherein the mechanical breaker (12) comprises a fixed contact and a mobile contact movable between a circuit-closing position where the mobile contact is in contact with the fixed contact and a circuit-opening position where the mobile contact is separated from the fixed contact.

**Patentansprüche**

1. Leistungsschalter (2), welcher aufweist:

einen ersten Induktor (11), der einen ersten externen Verbindungsanschluss ($T_1$) aufweist;
einen mechanischen Unterbrecher (12), der in Reihe mit dem ersten Induktor (11) geschaltet ist und der einen zweiten externen Verbindungsanschluss ($T_2$) auf einer Seite davon aufweist, die gegenüber der anderen Seite davon ist, und der mit dem ersten Induktor (11) verbunden ist, wobei der mechanische Unterbrecher (12) geöffnet wird, um einen aktuellen Pfad als Antwort auf einen Befehl zu unterbrechen;
einen oder mehrere Halbleiterleistungswandler (13), die einzeln oder in einer Form, die in einer Kaskade miteinander verbunden ist, auf einem Draht vorgesehen sind, der von einem Draht abzweigt, der den ersten Induktor (11) mit dem mechanischen Unterbrecher (12) verbindet, und die einen bestimmten direkten Strom ausgeben, indem sie einen Halbleiterschalter (S), der in jedem der einen oder mehreren Halbleiterleistungswandler (13) vorgesehen ist, einen Schaltvorgang als Antwort auf einen Befehl ausführen lassen; und
einen zweiten Induktor (14), der in Reihe mit dem einen oder den mehreren Halbleiterleistungswandlern (13) geschaltet ist; wobei der eine oder die mehreren Halbleiterleistungswandler (13) aufweisen:

einen DCDC-Wandler (21), der einen Gleichstromeingang von einer ersten Gleichstromseite und einer zweiten Gleichstromseite in einen Gleichstrom einer gewünschten Größe und Polarität umwandelt und der den Strom durch den Schaltvorgang des Halbleiterschalters (S) auf die andere Seite ausgibt, wobei der DCDC-Wandler (21) eine Eingangs- / Ausgangsrichtung des Gleichstroms bidirektional zwischen der ersten und der zweiten Gleichstromseite umschalten kann;

eine Energiespeichereinheit (22), die parallel zu der zweiten Gleichstromseite geschaltet ist, die der ersten Gleichstromseite gegenüberliegt, und die mit dem zweiten Induktor (14) oder einem anderen Halbleiterleistungswandler verbunden ist, der sich von dem Halbleiterleistungswandler (13) unterscheidet; und einen nichtlinearen Widerstand (23), der parallel zu der Energiespeichereinheit (22) geschaltet ist, wobei der Widerstand einen bestimmten Widerstandswert aufweist, wenn eine an die Energiespeichereinheit (22) angelegte Gleichspannung gleich oder niedriger als eine voreingestellte Spannung ist, und er ansonsten einen Widerstandswert zeigt, der niedriger als der bestimmte Widerstandswert ist, wobei der Energiespeicher (22) aufweist:

einen ersten Kondensator ($C_1$), der parallel zu dem nichtlinearen Widerstand (23) geschaltet ist; einen zweiten Kondensator ($C_2$), der eine größere Kapazität und eine niedrigere Ladespannung als die des ersten Kondensators ($C_1$) aufweist; und eine Halbleiterventilvorrichtung (37), die in Reihe mit dem zweiten Kondensator ($C_2$) geschaltet ist und die als Antwort auf einen Befehl einen Ladestrom steuert, der in den zweiten Kondensator ($C_2$) fließt, wobei diese Vorrichtung ein Halbleiterschaltelement, das, wenn es eingeschaltet wird, ermöglicht, dass ein Strom unidirektional fließt, und eine antiparallele Rückkopplungsdiode aufweist, die mit dem Halbleiterschaltelement antiparallel geschaltet ist, wobei der eine oder die mehreren Halbleiterleistungswandler (13) und der zweite Induktor (14), die beide auf demselben Draht angeordnet sind, eine Einheit bilden, die parallel zu dem mechanischen Unterbrecher geschaltet ist, wobei der zweite Kondensator ($C_2$) und die Halbleiterventilvorrichtung (37) eine Reihenschaltung bilden, die parallel zu dem ersten Kondensator ($C_1$) geschaltet ist.

2. Leistungsschalter (3), welcher aufweist:

einen ersten Induktor (11), der einen ersten externen Verbindungsanschluss ($T_1$) aufweist; einen zweiten Induktor (14), der in Reihe mit dem ersten Induktor (11) geschaltet ist; einen mechanischen Unterbrecher (12), der in Reihe mit dem zweiten Induktor (14) geschaltet ist und der einen zweiten externen Verbindungsanschluss ($T_2$) auf einer Seite davon aufweist, die gegenüber der anderen Seite davon ist, und der mit dem zweiten Induktor (14) verbunden ist, wobei der mechanische Unterbrecher (12) geöffnet wird, um einen aktuellen Pfad als Antwort auf einen Befehl zu unterbrechen; einen oder mehrere Halbleiterleistungswandler (13), die einzeln oder in einer Form, die in einer Kaskade miteinander verbunden ist, auf einem Draht vorgesehen sind, der von einem Draht abzweigt, der den ersten Induktor (11) mit dem mechanischen Unterbrecher (12) verbindet, und die einen bestimmten direkten Strom ausgeben, indem sie einen Halbleiterschalter (S), der in jedem der einen oder mehreren Halbleiterleistungswandler (13) vorgesehen ist, einen Schaltvorgang als Antwort auf einen Befehl ausführen lassen; und wobei jeder der einen oder mehreren Halbleiterleistungswandler (13) aufweist:

einen DCDC-Wandler (21), der einen Gleichstromeingang von einer ersten Gleichstromseite und einer zweiten Gleichstromseite in einen Gleichstrom einer gewünschten Größe und Polarität umwandelt und der den Strom durch den Schaltvorgang des Halbleiterschalters (S) auf die andere Seite ausgibt, wobei der DCDC-Wandler (21) eine Eingangs- / Ausgangsrichtung des Gleichstroms bidirektional zwischen der ersten und der zweiten Gleichstromseite umschalten kann; eine Energiespeichereinheit (22), die parallel zu der zweiten Gleichstromseite geschaltet ist, die gegenüber der ersten Gleichstromseite ist, und die mit dem zweiten Induktor (14) oder einen anderen Halbleiterleistungswandler verbunden ist, der sich von dem Halbleiterleistungswandler (13) unterscheidet; und einen nichtlinearen Widerstand (23), der parallel zu der Energiespeichereinheit (22) geschaltet ist, wobei dieser Widerstand einen bestimmten Widerstandswert aufweist, wenn eine an die Energiespeichereinheit (22) angelegte Gleichspannung gleich oder niedriger als eine voreingestellte Spannung ist, und er ansonsten einen Widerstandswert zeigt, der niedriger als der bestimmte Widerstandswert ist, wobei der Energiespeicher (22) aufweist:

einen ersten Kondensator (C1), der parallel zu dem nichtlinearen Widerstand (23) geschaltet ist; einen zweiten Kondensator (C2), der eine größere Kapazität und eine niedrigeren Ladespannung als die des ersten Kondensators (C1) aufweist; und eine Halbleiterventilvorrichtung (37), die in Reihe mit dem zweiten Kondensator ($C_2$) geschaltet ist und die als Antwort auf einen Befehl einen Ladestrom steuert, der in den zweiten Kondensator ($C_2$) fließt, wobei diese Vorrichtung ein Halbleiterschaltelement, das, wenn es eingeschaltet wird, ermöglicht, dass ein Strom unidirektional fließt, und eine antiparallele Rückkopplungsdiode aufweist, die mit dem Halbleiterschaltelement antiparallel geschaltet ist, wobei der eine oder die mehreren Halbleiterleistungswandler (13) parallel zu der Einheit geschaltet sind, die den zweiten Induktor (14) und den mechanischen Unterbrecher (12) aufweist, die in Reihe miteinander geschaltet sind, wobei der zweite Kondensator (C2) und die Halbleiterventilvorrichtung (37) eine Reihenschaltung bilden, die parallel zu dem ersten Kondensator ($C_1$) geschaltet ist.

3. Leistungsschalter (2, 3) nach einem der Ansprüche 1 oder 2, welcher aufweist:

eine Überstromerfassungseinheit, die erfasst, ob an einem externen Kabel, das mit dem ersten oder zweiten externen Verbindungsanschluss ($T_1$, $T_2$) verbunden ist, ein Überstrom aufgetreten ist oder nicht; und
eine Steuereinheit (32), die den Öffnungsvorgang des mechanischen Leistungsschalters (12), den Leistungsumwandlungsvorgang des DCDC-Wandlers (21) in dem einen oder den mehreren Halbleiterleistungswandlern (13) und den Ein-Aus-Betrieb des Halbleiterschaltelements in der Halbleiterventilvorrichtung (37) steuert, wobei die Steuereinheit (32) aufweist:

eine erste Befehlseinrichtung (41) zum Ausgeben eines Öffnungsbefehls, der dem mechanischen Unterbrecher (12) anweist, den Öffnungsvorgang zu starten, wenn die Überstromerfassungseinheit einen Überstrom erfasst;
eine zweite Befehlseinrichtung (42) zum Ausgeben eines Leistungsumwandlungsbefehls, wodurch der DCDC-Wandler (21) in dem einen oder den mehreren Halbleiterleistungswandlern (13) einen Gleichstrom ausgibt, der die Konvergenz eines durch den mechanischen Leistungsschalter (12) fließenden Stroms gegen Null während eines Zeitraums von der Ausgabe des Öffnungsbefehls bis zum Abschluss des Öffnungsvorgangs des mechanischen Leistungsschalters (12) bewirkt,
eine dritte Befehlseinrichtung (43) zum Ausgeben eines Ausschaltbefehls zum Ausschalten des Halbleiterschalters (S) in dem einen oder den mehreren Halbleiterleistungswandlern (13) nach Beendigung des Öffnungsvorgangs des mechanischen Leistungsschalters (1, 2, 3), und
eine vierte Befehlseinrichtung (44) zum Ausgeben eines Schaltbefehls, der das Halbleiterschaltelement in der Halbleiterventilvorrichtung (37) einschaltet, während die zweite Befehlseinrichtung (42) den Leistungsumwandlungsbefehl an den DCDC-Wandler (21) ausgibt, und der ansonsten das Halbleiterschaltelement in der Halbleiterventilvorrichtung (37) ausschaltet.

4. Leistungsschalter (2, 3) nach einem der vorhergehenden Ansprüche, wobei der Halbleiterschalter (S) aufweist:

ein Halbleiterschaltelement, das, wenn es eingeschaltet ist, ermöglicht, einen Strom unidirektional fließen zu lassen; und
eine Rückkopplungsdiode, die antiparallel mit dem Halbleiterschaltelement verbunden ist.

5. Leistungsschalter (2, 3) nach einem der vorhergehenden Ansprüche, wobei der mechanische Leistungsschalter (12) einen festen Kontakt und einen beweglichen Kontakt aufweist, der zwischen einer Position zum Schließen des Stromkreises, in der der mobile Kontakt mit dem festen Kontakt in Kontakt steht und eine Position zum Öffnen des Stromkreises bewegt werden kann, in der der mobile Kontakt von dem festen Kontakt getrennt ist.

## Revendications

1. Disjoncteur (2) comprenant :

une première bobine d'induction (11) comprenant une première borne de connexion externe ($T_1$) ;
un disjoncteur mécanique (12) étant connecté en série au premier inducteur (11) et comprenant une seconde borne de connexion externe ($T_2$) sur un côté de celui-ci opposé à l'autre côté de celui-ci connecté à la première bobine d'induction (11), lequel disjoncteur mécanique (12) est ouvert pour interrompre un trajet de courant en réponse à un ordre ;
un ou plusieurs convertisseurs de puissance à semi-conducteur (13) qui sont disposés individuellement ou sous une forme connectés en cascade l'un à l'autre sur un fil se ramifiant à partir d'un fil connectant la première bobine d'induction (11) au disjoncteur mécanique (12), et délivrent un certain courant continu en faisant en sorte qu'un commutateur à semi-conducteur (S) disposé dans chacun des un ou plusieurs convertisseurs de puissance à semi-conducteur (13) effectue une opération de commutation en réponse à un ordre ; et
une seconde bobine d'induction (14) connectée en série avec les un ou plusieurs convertisseurs de puissance à semi-conducteur (13) ; dans lequel les un ou plusieurs convertisseurs de puissance à semi-conducteur (13) comprennent :

un convertisseur DCDC (21) convertissant une entrée de courant continu de l'un d'un premier côté DC et d'un second côté DC en un courant continu d'une amplitude et d'une polarité souhaitées et délivrant le courant à l'autre côté par l'opération de commutation du commutateur à semi-conducteur (S), lequel convertisseur DCDC (21) peut commuter une direction d'entrée-sortie du courant continu de manière bidirectionnelle entre les premier et second côtés DC ;

une unité de stockage d'énergie (22) connectée en parallèle avec le second côté DC opposé au premier côté DC connecté à la seconde bobine d'induction (14) ou à un autre convertisseur de puissance à semi-conducteur différent du convertisseur de puissance à semi-conducteur (13) ; et

une résistance non linéaire (23) connectée en parallèle à l'unité de stockage d'énergie (22), laquelle résistance présente une certaine valeur de résistance lorsqu'une tension continue DC appliquée à l'unité de stockage d'énergie (22) est inférieure ou égale à une tension prédéfinie, et présente autrement une valeur de résistance inférieure à la certaine valeur de résistance, dans lequel l'unité de stockage d'énergie (22) comprend :

un premier condensateur ($C_1$) connecté en parallèle à la résistance non linéaire (23) ;

un second condensateur ($C_2$) ayant une capacité supérieure et une tension de charge inférieure à celles du premier condensateur ($C_1$) ; et

un dispositif de soupape à semi-conducteur (37) étant connecté en série au second condensateur ($C_2$) et commandant, en réponse à un ordre, un courant de charge circulant dans le second condensateur ($C_2$), lequel dispositif comprend un élément de commutation à semi-conducteur permettant, lorsqu'il est activé, à un courant de circuler de manière unidirectionnelle et une diode de rétroaction connectée en antiparallèle avec l'élément de commutation à semi-conducteur, dans lequel les un ou plusieurs convertisseurs de puissance à semi-conducteur (13) et la seconde bobine d'induction (14) tous deux placés sur le même fil configurent une unité connectée en parallèle avec le disjoncteur mécanique, dans lequel le second condensateur ($C_2$) et le dispositif de soupape à semi-conducteur (37) configurent un circuit en série connecté en parallèle avec le premier condensateur ($C_1$).

2. Disjoncteur (3) comprenant :

une première bobine d'induction (11) comprenant une première borne de connexion externe ($T_1$) ;

une seconde bobine d'induction (14) étant connectée en série à la première bobine d'induction (11) ;

un disjoncteur mécanique (12) étant connecté en série à la seconde bobine d'induction (14) et comprenant une seconde borne de connexion externe ($T_2$) sur un côté de celui-ci opposé à l'autre côté de celui-ci connecté à la seconde bobine d'induction (14), lequel disjoncteur mécanique (12) est ouvert pour interrompre un trajet de courant en réponse à un ordre ;

un ou plusieurs convertisseurs de puissance à semi-conducteur (13) qui sont disposés individuellement ou sous une forme connectés en cascade l'un à l'autre sur un fil se ramifiant à partir d'un fil connectant la première bobine d'induction (11) à la seconde bobine d'induction (14), et délivrent un certain courant continu en faisant en sorte qu'un commutateur à semi-conducteur (S) disposé dans chacun des un ou plusieurs convertisseurs de puissance à semi-conducteur (13) effectue une opération de commutation en réponse à un ordre ; et

dans lequel chacun des un ou plusieurs convertisseurs de puissance à semi-conducteur (13) comprend :

un convertisseur DCDC (21) convertissant une entrée de courant continu de l'un d'un premier côté DC et d'un second côté DC en un courant continu d'une amplitude et d'une polarité souhaitées et délivrant le courant à l'autre côté par l'opération de commutation du commutateur à semi-conducteur (S), lequel convertisseur DCDC (21) peut commuter une direction d'entrée-sortie du courant continu de manière bidirectionnelle entre les premier et second côtés DC ;

une unité de stockage d'énergie (22) connectée en parallèle avec le second côté DC opposé au premier côté DC connecté à la seconde bobine d'induction (14) ou à un autre convertisseur de puissance à semi-conducteur différent du convertisseur de puissance à semi-conducteur (13) ; et

une résistance non linéaire (23) connectée en parallèle à l'unité de stockage d'énergie (22), laquelle résistance présente une certaine valeur de résistance lorsqu'une tension continue DC appliquée à l'unité de stockage d'énergie (22) est inférieure ou égale à une tension prédéfinie, et présente autrement une valeur de résistance inférieure à la certaine valeur de résistance, dans lequel l'unité de stockage d'énergie (22) comprend :

un premier condensateur ($C_1$) connecté en parallèle avec la résistance non linéaire (23) ;

un second condensateur ($C_2$) ayant une capacité supérieure et une tension de charge inférieure à celles du premier condensateur ($C_1$) ; et

un dispositif de soupape à semi-conducteur (37) étant connecté en série avec le second condensateur ($C_2$) et commandant, en réponse à un ordre, un courant de charge circulant dans le second condensateur ($C_2$), lequel dispositif comprend un élément de commutation à semi-conducteur permettant, lorsqu'il est activé, à un courant de circuler de manière unidirectionnelle et une diode de rétroaction connectée en antiparallèle avec l'élément de commutation à semi-conducteur, dans lequel les un ou plusieurs convertisseurs de puissance à semi-conducteur (13) sont connectés en parallèle avec l'unité comprenant la seconde bobine d'induction (14) et le disjoncteur mécanique (12) connectés en série l'un à l'autre, dans lequel le second condensateur ($C_2$) et le dispositif de soupape à semi-conducteur (37) configurent un circuit en série connecté en parallèle avec le premier condensateur ($C_1$).

3. Disjoncteur (2, 3) selon l'une quelconque de la revendication 1 ou 2, comprenant :

une unité de détection de surintensité détectant si une surintensité s'est produite ou non sur un fil externe connecté à la première ou à la seconde borne de connexion externe ($T_1$, $T_2$) ; et

une unité de commande (32) commandant l'opération d'ouverture du disjoncteur mécanique (12), l'opération de conversion de puissance du convertisseur DCDC (21) dans les un ou plusieurs convertisseurs de puissance à semi-conducteur (13), et l'opération d'activation-désactivation de l'élément de commutation à semi-conducteur dans le dispositif de soupape à semi-conducteur (37), dans lequel l'unité de commande (32) comprend

des premiers moyens d'ordre (41) pour délivrer, lorsque l'unité de détection de surintensité détecte une surintensité, un ordre d'ouverture ordonnant au disjoncteur mécanique (12) de démarrer l'opération d'ouverture,

des deuxièmes moyens d'ordre (42) pour délivrer en sortie un ordre de conversion de puissance amenant le convertisseur DCDC (21) des un ou plusieurs convertisseurs de puissance (13) à délivrer un courant continu qui fait converger à zéro un courant circulant à travers le disjoncteur mécanique (12) pendant une période allant de la sortie de l'ordre d'ouverture à l'achèvement de l'opération d'ouverture du disjoncteur mécanique (12),

des troisièmes moyens d'ordre (43) pour délivrer en sortie un ordre de désactivation désactivant le commutateur à semi-conducteur (S) dans les un ou plusieurs convertisseurs de puissance à semi-conducteur (13) lors de l'achèvement de l'opération d'ouverture du disjoncteur mécanique (1, 2, 3), et

des quatrièmes moyens d'ordre (44) pour délivrer en sortie un ordre de commutation activant l'élément de commutation à semi-conducteur dans le dispositif de soupape à semi-conducteur (37) tandis que les deuxièmes moyens d'ordre (42) délivrent l'ordre de conversion de puissance au convertisseur DCDC (21), et autrement désactivant l'élément de commutation à semi-conducteur dans le dispositif de soupape à semi-conducteur (37).

4. Disjoncteur (2, 3) selon 'une quelconque des revendications précédentes, dans lequel le commutateur à semi-conducteur (S) comprend :

un élément de commutation à semi-conducteur permettant, lorsqu'il est activé, à un courant de circuler de manière unidirectionnelle ; et

une diode de rétroaction connectée en antiparallèle à l'élément de commutation à semi-conducteur.

5. Disjoncteur (2, 3) selon l'une quelconque des revendications précédentes, dans lequel le disjoncteur mécanique (12) comprend un contact fixe et un contact mobile déplaçable entre une position de fermeture de circuit où le contact mobile est en contact avec le contact fixe et une position d'ouverture de circuit où le contact mobile est séparé du contact fixe.

**FIG. 1**

**FIG. 2**

FIG. 3A

# FIG. 3B

FIG. 3C

# FIG. 4

LOAD CURRENT →
(=SOURCE CURRENT)

OVER-CURRENT
DETECTION UNIT

31

CONTROL UNIT

32

41

FIRST COMMAND MEANS → OPENING
COMMAND

42

SECOND COMMAND MEANS → POWER
CONVERSION
COMMAND

43

THIRD COMMAND MEANS → OFF
COMMAND

# FIG. 5

```
                    ┌─────────────┐
                    │    START    │
                    └─────────────┘
                           │
         ┌─────────────────┤
         │                 ▼
         │          ┌───────────────┐
         │          │    NORMAL     │────── S101
         │          │   OPERATION   │
         │          └───────────────┘
         │                 │
         │                 ▼           S102
         │  No     ◇─────────────────◇
         └─────────  OVER-CURRENT     
                    ◇   OCCURRED?     ◇
                     ◇───────────────◇
                           │
                          Yes
                           ▼
                    ┌───────────────┐
                    │    OUTPUT     │────── S103
                    │ OPENING COMMAND│
                    └───────────────┘
                           │
                           ▼
                    ┌───────────────┐
                    │  OUTPUT POWER │────── S104
                    │CONVERSION COMMAND│
                    └───────────────┘
                           │
                           ▼
                    ┌───────────────┐
                    │    OPENING    │────── S105
                    │   OPERATION   │
                    └───────────────┘
                           │
                           ▼
                    ┌───────────────┐
                    │    OUTPUT     │────── S106
                    │  OFF-COMMAND  │
                    └───────────────┘
                           │
                           ▼
                    ┌─────────────┐
                    │     END     │
                    └─────────────┘
```

FIG. 6A
$t < t_0$

FIG. 6B
$t_0 \leqq t < t_1$

FIG. 6C
$t_1 \leqq t < t_2$

FIG. 6D
$t_2 \leqq t < t_3$

FIG. 7

$i_{HB} - i_S$ → [ PI ] B1 → + ⊕ + → $v_j^*$ → [ $1/v_{C1}$ ] B4₁ →

[ $1/v_{C2}$ ] B4₂ →

B3 → [ 1/N ] ← ↑ $v_f$

B2 ⌐ ─ ─ ─ ┐

$i_S$ → [ $L_1 \dfrac{d}{dt}$ ] → − ⊕ + → $v_f$

$V_{dc}$

[ $1/v_{CN}$ ] B4ₙ →

FIG. 8A

$i_S$ → |1| → $i_L$ →

$V_{dc}$ ⎓

CIRCUIT BREAKER

FAULT

[ 30 Ω (=500A) ]

[ 0.3mH ]

FIG. 8B

$i_S$ → |1| → $i_L$ →

$V_{dc}$ ⎓

CIRCUIT BREAKER

FAULT

⊕ 500A

# FIG. 9

| RATED CAPACITANCE | P | 7. 5MW |
|---|---|---|
| RATED DC VOLTAGE | $V_{dc}$ | 15kV |
| RATED SOURCE CURRENT | $I_S$ | 500A |
| RATED LOAD CURRENT | $I_L$ | 500A |
| INDUCTANCE OF FIRST INDUCTOR | $L_1$ | 10mH |
| RATE OF CURRENT INCREASE | $V_{dc}/L_1$ | 1. 5kA/ms |
| INDUCTANCE OF SECOND INDUCTOR | $L_2$ | 0. 5mH |
| NUMBER OF SEMICONDUCTOR POWER CONVERTER | N | 10 |
| CARRIER FREQUENCY | $f_C$ | 2kHz |
| DC CAPACITOR VOLTAGE DURING POWER CONVERSION OPERATION | $V_C$ | 1. 5kV |
| CAPACITANCE OF DC CAPACITOR | C | 5. 0mF |
| UNIT ELECTROSTATIC CONSTANT | H | 7. 5ms |

# FIG. 10

FIG. 11

# FIG. 12

# FIG. 13

# FIG. 14

# FIG. 15

# FIG. 16

FIG. 17

# FIG. 18A

# FIG. 18B

FIG. 19

# FIG. 20

# FIG. 21

FIG. 22A

23

22

D₁  C₂

C₁

FIG. 22B

23

22

D₁  C₂

C₁

FIG. 22C

23

22

D₁  C₂

C₁

FIG. 23

# FIG. 24

FIG. 25

FIG. 26

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014094847 A

**Non-patent literature cited in the description**

- **B. BACHMANN ; G. MAUTHE ; E. RUOSS ; H. P. LIPS.** Development of a 500 kV Airblast HVDC Circuit Breaker. *IEEE Transactions, Electrical Power Apparatus and Systems,* September 1985, vol. 104 (9), 2460-2466
- **C E MEYERS ; S. SCHRODER ; R. W. DE DONCKER.** Solid-State Circuit Breakers and Current Limiters For Medium-Voltage Systems Having Distributed Power Systems. *IEEE Transactions, Power Electron,* September 2004, vol. 19 (5), 1333-1340
- **M.STEURER ; K. FROHLICH ; W. HOLAUS ; K. KALTENEGGER.** A Novel Hybrid Current-Limiting Circuit Breaker For Medium Voltage: Principle and Test Results. *IEEE Transactions, Power Deli,* April 2003, vol. 18 (2), 460-467